# EUROPEAN PATENT APPLICATION

(11) **EP 4 564 434 A1**
(43) Date of publication of application: **04.06.2025**
(21) Application number: 23846304.6
(22) Date of filing: 18.07.2023
(51) Int. Cl.: H01L 27/146, H04N 25/70

(54) **IMAGING DEVICE AND ELECTRONIC APPLIANCE**

(30) Priority: 27.07.2022 JP 2022119695
(71) Applicant: Sony Semiconductor Solutions Corporation, Atsugi-shi, Kanagawa 243-0014 (JP)
(72) Inventor: KAGAWA, Yoshihisa, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/026276
(87) International publication number: WO 2024/024573

(57) **Abstract**

An imaging device and an electronic apparatus capable of suppressing deterioration of device characteristics are provided. An imaging device includes a sensor board having a pixel region in which a plurality of pixels that performs photoelectric conversion is arranged side by side, a circuit board bonded to one surface side of the sensor substrate, the circuit board including circuits that process signals input to the sensor board or signals output from the sensor board, and a voltage supply terminal that is provided on an opposite side of a surface of the circuit board facing the sensor board and that supplies a power supply voltage or a reference voltage to the circuits. At least a subset of the voltage supply terminal is arranged at a position overlapping the pixel region in a thickness direction of the multilayer board including the sensor board and the circuit board.

## Description

### TECHNICAL FIELD

The present technology relates to an imaging device and an electronic apparatus.

### BACKGROUND ART

Configurations in which a plurality of semiconductor substrates is stacked on one another have been proposed for imaging devices such as CMOS image sensors (see, for example, Patent Document 1).

### CITATION LIST

### PATENT DOCUMENT

Patent Document 1: Japanese Patent Application Laid-Open No. 2014-72294

### SUMMARY OF THE INVENTION

### PROBLEMS TO BE SOLVED BY THE INVENTION

An imaging device includes a pixel region in which pixels are regularly arranged in a two-dimensional array, and a peripheral region located around the pixel region. An electrode pad arranged in the peripheral region and logic circuits arranged at positions overlapping the pixel region are connected to each other by wiring, and a power supply voltage or the like is supplied to the logic circuits via the wiring. In a case where the number of stacked wirings or the number of stacked semiconductor substrates increases, wiring length from the electrode pad to the logic circuits increases, and IR drop (voltage drop) becomes likely to occur. IR drop might cause deterioration of device characteristics. In particular, in a case where a state-of-the-art device requiring high-speed operation is used, deterioration of device characteristics due to IR drop tends to be noticeable.

The present disclosure has been made in view of such circumstances, and an object thereof is to provide an imaging device and an electronic apparatus capable of suppressing deterioration of device characteristics.

### SOLUTIONS TO PROBLEMS

An imaging device according to an aspect of the present disclosure includes a sensor board having a pixel region in which a plurality of pixels that performs photoelectric conversion is arranged side by side, a circuit board bonded to one surface side of the sensor substrate, the circuit board including circuits that process signals input to the sensor board or signals output from the sensor board, and a voltage supply terminal that is provided on an opposite side of a surface of the circuit board facing the sensor board and that supplies a power supply voltage or a reference voltage to the circuits. At least a subset of the voltage supply terminal is arranged at a position overlapping the pixel region in a thickness direction of the multilayer board including the sensor board and the circuit board.

According to this, the power supply voltage or the reference voltage is supplied to the circuits of the circuit board from the opposite side (for example, a back surface of the circuit board) of the surface of the circuit board facing the sensor board. For example, as compared with a case where the power supply voltage or the reference voltage is supplied to the circuits of the circuit board from a side of a peripheral region of the sensor board, the imaging device can shorten routes (hereinafter also referred to as voltage supply routes) for supplying the power supply voltage or the reference voltage and length of wiring to which the voltage is applied. As a result, the imaging device can suppress IR drop, and can suppress deterioration of device characteristics.

An electronic apparatus according to another aspect of the present disclosure includes an imaging device and an optical system that causes the imaging device to form an image with image light from a subject. The imaging device includes a sensor board having a pixel region in which a plurality of pixels that performs photoelectric conversion is arranged side by side, a circuit board bonded to one surface side of the sensor substrate, the circuit board including circuits that process signals input to the sensor board or signals output from the sensor board, and a voltage supply terminal that is provided on an opposite side of a surface of the circuit board facing the sensor board and that supplies a power supply voltage or a reference voltage to the circuits. At least a subset of the voltage supply terminal is arranged at a position overlapping the pixel region in a thickness direction of the multilayer board including the sensor board and the circuit board.

According to this, since the electronic apparatus includes the imaging device capable of suppressing deterioration of device characteristics due to IR drop, it is possible to suppress deterioration of performance.

### BRIEF DESCRIPTION OF DRAWINGS

Fig. 1 is a diagram illustrating a configuration example of an imaging device according to a first embodiment of the present disclosure.
Fig. 2 is a circuit diagram illustrating a configuration example of a pixel.
Fig. 3 is a plan view schematically illustrating an arrangement example of a pixel region and a peripheral region in a sensor board.
Fig. 4 is a cross-sectional view illustrating a configuration example of the imaging device according to the first embodiment of the present disclosure.
Fig. 5 is a plan view illustrating an arrangement example of bump electrodes according to the first embodiment of the present disclosure.
Fig. 6 is a cross-sectional view illustrating a configuration example of each of vias according to the first embodiment of the present disclosure.
Fig. 7 is a diagram schematically illustrating routes (voltage supply routes) for supplying a power supply voltage or a reference voltage from the bump electrodes for supplying voltages to logic circuits in the imaging device according to the first embodiment of the present disclosure.
Fig. 8A is a cross-sectional view illustrating a method for manufacturing the imaging device according to the first embodiment of the present disclosure in order of steps.
Fig. 8B is another cross-sectional view illustrating the method for manufacturing the imaging device according to the first embodiment of the present disclosure in order of steps.
Fig. 8C is another cross-sectional view illustrating the method for manufacturing the imaging device according to the first embodiment of the present disclosure in order of steps.
Fig. 8D is another cross-sectional view illustrating the method for manufacturing the imaging device according to the first embodiment of the present disclosure in order of steps.
Fig. 8E is another cross-sectional view illustrating the method for manufacturing the imaging device according to the first embodiment of the present disclosure in order of steps.
Fig. 8F is another cross-sectional view illustrating the method for manufacturing the imaging device according to the first embodiment of the present disclosure in order of steps.
Fig. 8G is another cross-sectional view illustrating the method for manufacturing the imaging device according to the first embodiment of the present disclosure in order of steps.
Fig. 8H is another cross-sectional view illustrating the method for manufacturing the imaging device according to the first embodiment of the present disclosure in order of steps.
Fig. 9 is a cross-sectional view illustrating configuration of an imaging device according to Comparative Example 1 of the present disclosure.
Fig. 10 is a cross-sectional view illustrating configuration of an imaging device according to Comparative Example 2 of the present disclosure.
Fig. 11 is a cross-sectional view illustrating configuration of an imaging device according to a first modification of the first embodiment of the present disclosure.
Fig. 12 is a cross-sectional view illustrating micro-vias of the imaging device according to the first modification of the first embodiment of the present disclosure.
Fig. 13 is a cross-sectional view illustrating a configuration example of an imaging device according to a second embodiment of the present disclosure.
Fig. 14 is a cross-sectional view illustrating a configuration example of each of vias according to the second embodiment of the present disclosure.
Fig. 15 is a diagram schematically illustrating voltage supply routes of the imaging device according to the second embodiment of the present disclosure.
Fig. 16 is a cross-sectional view illustrating configuration of an imaging device according to a first modification of the second embodiment of the present disclosure.
Fig. 17 is a diagram schematically illustrating voltage supply routes of the imaging device according to the first modification of the second embodiment of the present disclosure.
Fig. 18 is a cross-sectional view illustrating configuration of an imaging device according to a second modification of the second embodiment of the present disclosure.
Fig. 19 is a diagram schematically illustrating voltage supply routes of the imaging device according to the second modification of the second embodiment of the present disclosure.
Fig. 20 is a diagram illustrating a configuration example of an electronic apparatus to which the technology according to the present disclosure (present technology) can be applied.
Fig. 21 is a diagram illustrating an example of a schematic configuration of an endoscopic surgery system to which the technology according to the present disclosure (present technology) can be applied.
Fig. 22 is a block diagram illustrating an example of a functional configuration of a camera head and a camera control unit (CCU) illustrated in Fig. 21.
Fig. 23 is a block diagram illustrating a schematic configuration example of a vehicle control system, which is an example of a moving body control system to which the technology according to the present disclosure can be applied.
Fig. 24 is a diagram illustrating an example of an installation position of imaging sections.

### MODE FOR CARRYING OUT THE INVENTION

Embodiments of the present disclosure will be described hereinafter with reference to the drawings. In the illustration of the drawings referred to in the following description, the same or similar parts are given the same or similar reference signs. It should be noted that the drawings are schematic, and relationships between thicknesses and planar dimensions, ratios of thicknesses between individual layers, and the like are different from actual ones. Specific thicknesses and dimensions, therefore, should be determined in consideration of the following description. Furthermore, it goes without saying that dimensional relationships and ratios are partly different between the drawings.

Definitions of directions such as upward and downward in the following description are merely definitions for convenience of description, and do not limit the technical idea of the present disclosure. For example, it goes without saying that in a case where a target is rotated by 90° and observed, upward and downward are converted into rightward and leftward, and in a case where the target is rotated by 180° and observed, upward and downward are inverted.

In the following description, there will be a case where directions are described using terms such as an X-axis direction, a Y-axis direction, and a Z-axis direction. For example, the X-axis direction and the Y-axis direction are directions parallel to a back surface 1b of a sensor board 1, which will be described later. The back surface 1b of the sensor board 1 is also a back surface 111b of a multilayer board 111 including the sensor board 1 and a logic board 2, which will be described later. The X-axis direction and the Y-axis direction will also be referred to as a horizontal direction. The Z-axis direction is a normal direction of the back surface 11b of the sensor board 11 (that is, the back surface 111b of the multilayer board 111). The Z-axis direction is also a thickness direction of the multilayer board 111. The X-axis direction, the Y-axis direction, and the Z-axis direction are perpendicular to each other.

In the following description, "plan view" means, for example, viewing from the thickness direction (for example, the Z-axis direction) of the multilayer board 111.

### <First Embodiment>

### (Overall Configuration Example)

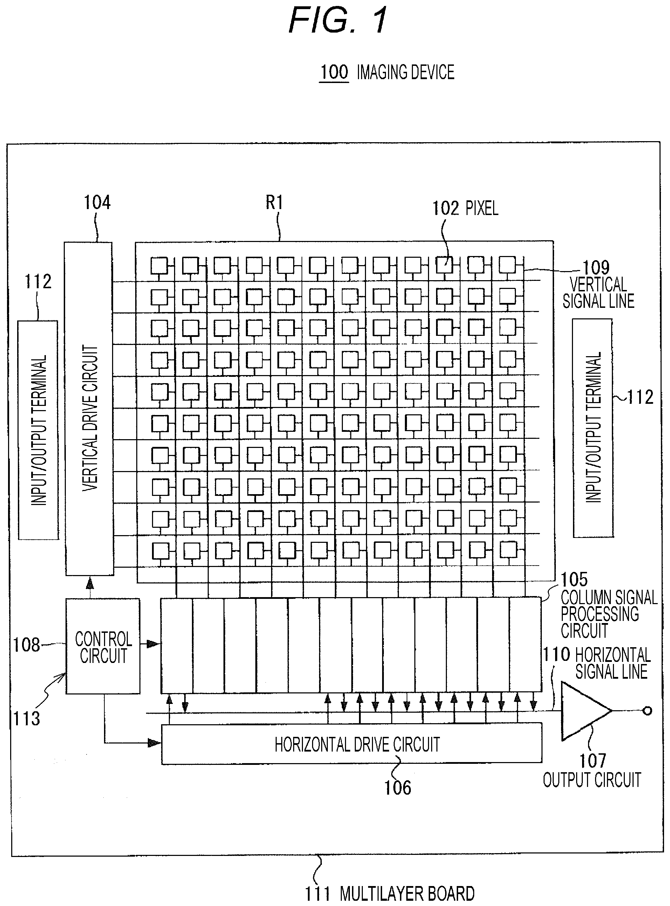

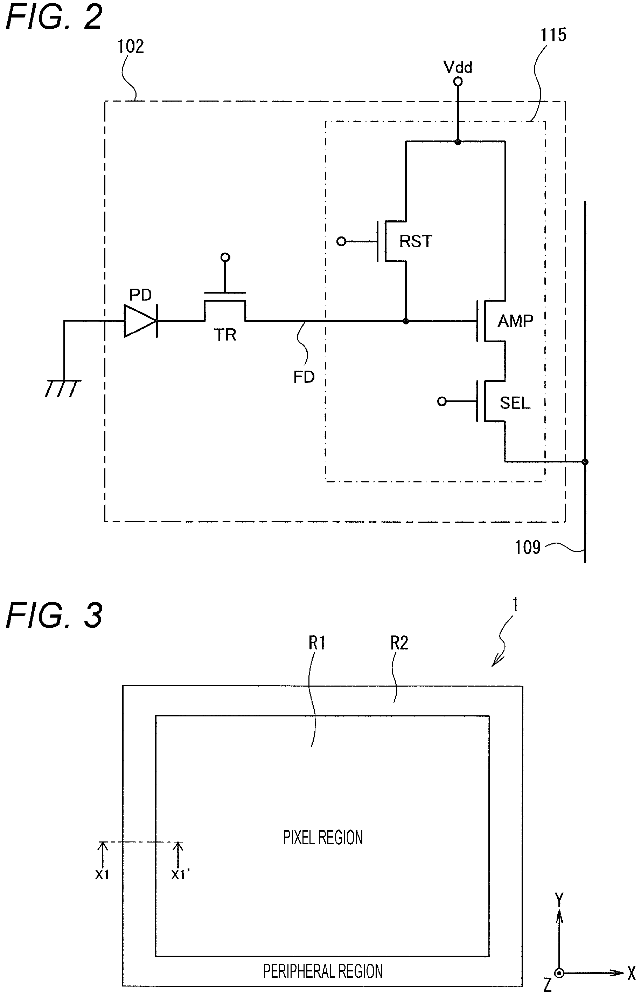

Fig. 1 is a diagram illustrating a configuration example of an imaging device 100 according to a first embodiment of the present disclosure. The imaging device 100 illustrated in Fig. 1 is, for example, a complenentary metal-oxide-semiconductor field effect transistor (CMOS) image sensor. As illustrated in Fig. 1, the imaging device 100 includes a pixel region (so-called imaging region) R1 in which a plurality of pixels 102 that performs photoelectric conversion is regularly arranged in two dimensions, and logic circuits 113 (an example of "circuits" of the present disclosure). The pixels 102 each include a photodiode as a photoelectric conversion element and pixel transistors. A configuration example of each pixel 102 will be described later with reference to Fig. 2.

The logic circuits 113 include, for example, a vertical drive circuit 104, column signal processing circuits 105, a horizontal drive circuit 106, an output circuit 107, and a control circuit 108. The logic circuits 113 are, for example, CMOS circuits. The CMOS circuits are circuits including n-channel MOSFETs and p-channel MOSFETs.

The control circuit 108 receives an input clock and data specifying an operation mode and the like and outputs data such as internal information regarding the imaging device. That is, the control circuit 108 generates, on the basis of a vertical synchronization signal, a horizontal synchronization signal, and a master clock, a clock signal and control signals on the basis of which the vertical drive circuit 104, the column signal processing circuits 105, the horizontal drive circuit 106, and the like operate. The control circuit 108 then inputs these signals to the vertical drive circuit 104, the column signal processing circuits 105, and the horizontal drive circuit 106.

The vertical drive circuit 104 is, for example, a shift register, selects a pixel drive wire, supplies a pulse for driving pixels to the selected pixel drive wire, and drives the pixels in units of rows. That is, the vertical drive circuit 104 sequentially selects and scans the individual pixels 102 in the pixel region R1 in the vertical direction in units of rows, and supplies pixel signals based on signal charges generated by photoelectric conversion elements of the individual pixels 102 in accordance with the amount of light received to a corresponding column signal processing circuit 105 through a corresponding vertical signal line 109.

The column signal processing circuit 105 is provided, for example, for each of columns of the pixels 102, and performs signal processing such as noise removal on signals output from one row of pixels 102 for each pixel column. That is, the column signal processing circuits 105 perform signal processing such as CDS for removing fixed pattern noise unique to the pixels 102, signal amplification, and analog-to-digital conversion (ADC). A horizontal selection switch (not illustrated) is provided and connected between an output stage of the column signal processing circuits 105 and a horizontal signal line 110.

The horizontal drive circuit 106 is, for example, a shift register, sequentially selects the individual column signal processing circuits 105 by sequentially outputting horizontal scanning pulses, and causes the individual column signal processing circuits 105 to output pixel signals to the horizontal signal line 110.

The output circuit 107 performs signal processing on the signals sequentially supplied from the individual column signal processing circuits 105 through the horizontal signal line 110, and outputs the processed signals. For example, the output circuit 107 might perform only buffering, or might perform black level adjustment, column variation correction, various types of digital signal processing, and the like. Input/output terminals 112 communicate signals with the outside.

Fig. 2 is a circuit diagram illustrating a configuration example of each pixel 102. The pixel 102 includes a photodiode PD, a transfer transistor TR, a floating diffusion FD, an amplification transistor AMP, a selection transistor SEL, and a reset transistor RST. The transfer transistor TR, the floating diffusion FD, the amplification transistor AMP, the selection transistor SEL, and the reset transistor RST constitute a read circuit 115 that reads charge (pixel signal) obtained as a result of photoelectric conversion performed by the photodiode PD.

The photodiode PD is a photoelectric conversion unit that converts incident light into charge through photoelectric conversion and accumulates the charge, and an anode terminal thereof is grounded and a cathode terminal thereof is connected to the transfer transistor TR. A transfer signal is supplied from the vertical drive circuit 104 to a gate electrode (hereinafter also referred to as a transfer gate) of the transfer transistor TR. The transfer transistor TR is driven in accordance with the transfer signal supplied to the transfer gate. In a case where the transfer transistor TR is turned on, the charge accumulated in the photodiode PD is transferred to the floating diffusion FD. The floating diffusion FD is a floating diffusion region having a predetermined accumulation capacity connected to a gate electrode of the amplification transistor AMP, and temporarily accumulates the charge transferred from the photodiode PD.

The amplification transistor AMP outputs a pixel signal of a level (that is, a potential of the floating diffusion FD) corresponding to the charge accumulated in the floating diffusion FD to the vertical signal line 109 via the selection transistor SEL. That is, with the configuration in which the floating diffusion FD is connected to the gate electrode of the amplification transistor AMP, the floating diffusion FD and the amplification transistor AMP function as a conversion unit that amplifies charge generated in the photodiode PD and that converts the charge into a pixel signal of a level corresponding to the charge.

The selection transistor SEL is driven in accordance with a selection signal supplied from the vertical drive circuit 104, and in a case where the selection transistor SEL is turned on, the pixel signal output from the amplification transistor AMP can be output to the vertical signal line 109. The reset transistor RST is driven in accordance with a reset signal supplied from the vertical drive circuit 104, and in a case where the reset transistor RST is turned on, the charge accumulated in the floating diffusion FD is discharged to a power supply line Vdd, and the floating diffusion FD is reset.

Note that the pixels 102 may have a shared pixel structure. The shared pixel structure includes a plurality of photodiodes PD, a plurality of transfer transistors TR, one shared floating diffusion FD, and one each of other shared pixel transistors (for example, an amplification transistor AMP, a selection transistor SEL, and a reset transistor RST). That is, in the shared pixel structure, the photodiodes PD and the transfer transistors TR constituting a plurality of unit pixels are configured to share one each of the pixel transistors other than the transfer transistors TR.

### (Configuration Example of Pixel Region and Peripheral Region)

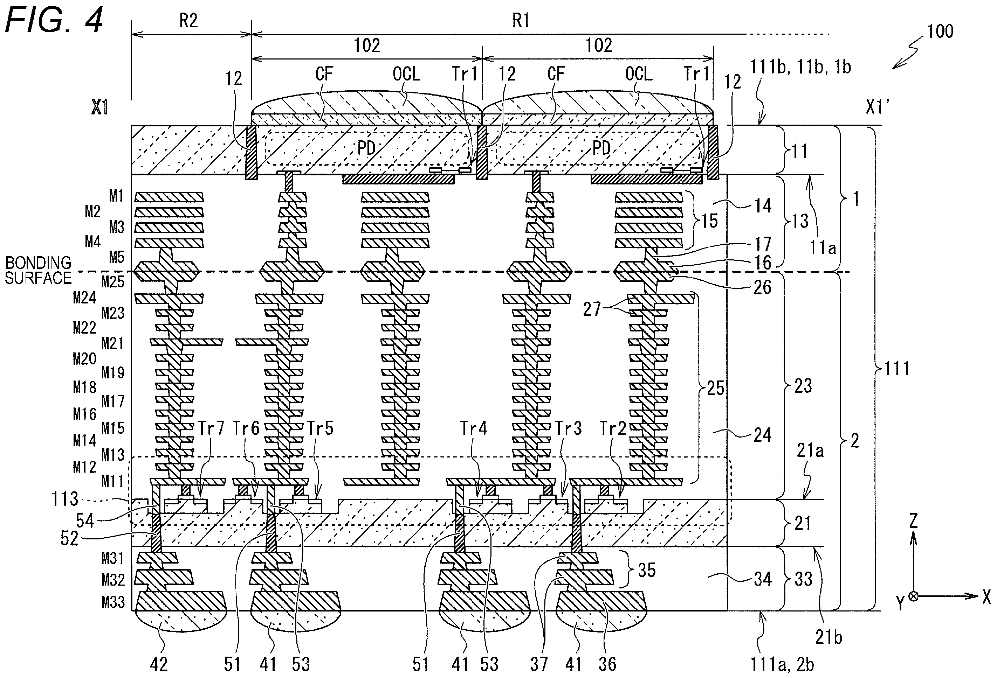

Fig. 3 is a plan view schematically illustrating an arrangement example of the pixel region and the peripheral region in the sensor board 1. As illustrated in Fig. 3, the sensor board 1 includes a pixel region R1 and a peripheral region R2 arranged around the pixel region R1. The pixel region R1 is a light receiving region that receives light focused by on-chip lenses OCL (see Fig. 4 referred to later), and includes the plurality of pixels 102. The peripheral region R2 is, for example, a region where the pixels 102 and the on-chip lenses OCL are not arranged. In the imaging device 100, the pixel region R1 is larger than the peripheral region R2 in area. Note that a light shielding film may be provided in the peripheral region R2 via an insulating film. In this case, the peripheral region R2 may be referred to as an optical black region.

Fig. 4 is a cross-sectional view illustrating a configuration example of the imaging device 100 according to the first embodiment of the present disclosure. Fig. 4 illustrates a cross-section of the plan view illustrated in Fig. 3 taken along line X1-X1' parallel to the X-axis direction. As illustrated in Fig. 4, the imaging device 100 is a back-illuminated CMOS image sensor on which light is incident from the back surface 1b (in Fig. 4, an upper surface) of the sensor board 1. The imaging device 100 includes the sensor board 1 including the pixel region R1 and the peripheral region R2 and the logic board 2 (an example of a "circuit board" of the present disclosure) including the logic circuits 113. The logic board 2 is bonded to a front surface 1a (in Fig. 4, a lower surface) side of the sensor board 1 to form the multilayer board 3.

The sensor board 1 includes the semiconductor substrate 11 (an example of a "second semiconductor layer" of the present disclosure) provided with the plurality of pixels 102. The semiconductor substrate 11 is, for example, a thin silicon film. The semiconductor substrate 11 is provided with the photodiodes PD as photoelectric conversion units arranged in the individual pixels 102, a separation unit 12 that separates adjacent pixels 102, and pixel transistors Tr1. The separation unit 12 has, for example, a shallow trench isolation (STI) structure.

As illustrated in Fig. 2, the pixels 102 each include a transfer transistor TR, a reset transistor RST, an amplification transistor AMP, and a selection transistor SEL. The pixel transistors Tr1 illustrated in Fig. 4 include these various transistors.

A wiring layer 13 (an example of a "third wiring layer" of the present disclosure) is provided on the front surface 11a side of the semiconductor substrate 11. The wiring layer 13 is a multilayer wiring layer, and includes an interlayer insulating film 14, wiring 15 arranged in multiple layers with the interlayer insulating film 14 interposed therebetween, connection pads 16 (an example of a "part of a conductor included in a third wiring layer" of the present disclosure), and vias 17. The vias 17 each connect the semiconductor substrate 11 to the wiring 15, a part of the wiring 15 to another part, or the wiring 15 to one of the connection pads 16 in the thickness direction (for example, in the Z-axis direction) of the multilayer board 111. The connection pads 16 face a bonding surface between the sensor board 1 and the logic board 2. Surfaces (in Fig. 4, lower surfaces) of the connection pads 16 are exposed from the interlayer insulating film 14.

Fig. 4 illustrates a case where the wiring 15 and the connection pads 16 are five layers of metal M1 to M5. The wiring 15, the connection pads 16, and the vias 17 contain, for example, copper (Cu) or a Cu alloy. The wiring 15, the connection pads 16, and the vias 17 may be formed by a single damascene method or a dual damascene method. Furthermore, at least a part of the wiring 15 and at least a subset of the vias 17 may contain aluminum (Al), an Al alloy, a conductive polysilicon film doped with impurities, or the like.

On a back surface (in Fig. 4, the upper surface) 11b side of the semiconductor substrate 11, the on-chip lenses OCL (examples of a "lens" of the present disclosure) are provided. Furthermore, a color filter CF is provided between each on-chip lens OCL and the back surface 11b of the semiconductor substrate 11. Note that Fig. 4 illustrates a mode in which the color filters CF and the on-chip lenses OCL are arranged in the pixel region R1 and not arranged in the peripheral region R2, but the present embodiment is not limited to this. In the present embodiment, the color filters CF and the on-chip lenses OCL may also be arranged not only in the pixel region R1 but also in the peripheral region R2.

The logic board 2 includes a semiconductor substrate 21 (an example of a "first semiconductor layer" of the present disclosure). The semiconductor substrate 21 has a front surface 21a (an example of a "first surface" of the present disclosure) facing the sensor board 1 and a back surface 21b (an example of a "second surface" of the present disclosure) located on an opposite side of the front surface 21a. The semiconductor substrate 21 contains silicon. A plurality of MOS transistors constituting the logic circuits 113 is provided on a front surface 21a (in Fig. 4, the upper surface) side of the semiconductor substrate 21. Fig. 4 illustrates n-channel or p-channel MOS transistors Tr2 to Tr7 as some of the plurality of MOS transistors constituting the logic circuits 113.

The pixel region R1 is larger than the peripheral region R2 in area. More logic circuits 113, therefore, are arranged at positions overlapping the pixel region R1 in the Z-axis direction than at positions overlapping the peripheral region R2 in the Z-axis direction. That is, more logic circuits 113 are arranged at positions overlapping the pixel region R1 in plan view than at positions overlapping the peripheral region R2 in plan view.

A wiring layer 23 (an example of a "first wiring layer" of the present disclosure) is provided on the front surface 21a side of the semiconductor substrate 21. The wiring layer 23 is a multilayer wiring layer, and includes an interlayer insulating film 24, wiring 25 arranged in multiple layers with the interlayer insulating film 24 interposed therebetween, connection pads 26 (an example of a "part of a conductor included in a first wiring layer" of the present disclosure), and vias 27. The vias 27 each connect the semiconductor substrate 21 to the wiring 25, a part of the wiring 25 to another part, or the wiring 25 to one of the connection pads 26 in the thickness direction (for example, in the Z-axis direction) of the multilayer board 111. The connection pads 26 face the bonding surface between the sensor board 1 and the logic board 2. Surfaces (in Fig. 4, upper surfaces) of the connection pads 26 are exposed from the interlayer insulating film 24. The connection pads 26 are bonded to the connection pads 16 in the wiring layer 13 described above.

Fig. 4 illustrates a case where the wiring 25 and the connection pads 26 are fifteen layers of metal M11 to M25. The wiring 25, the connection pads 26, and the vias 27 contain, for example, copper (Cu) or a Cu alloy. The wiring 25, the connection pads 26, and the vias 27 may be formed by a single damascene method or a dual damascene method. Furthermore, at least a part of the wiring 25 and at least a subset of the vias 27 may contain aluminum (Al), an Al alloy, a conductive polysilicon film doped with impurities, or the like.

On a back surface (in Fig. 4, a lower surface) 21b side of the semiconductor substrate 21, a wiring layer 33 (an example of a "second wiring layer" of the present disclosure) is provided. The wiring layer 33 is a multilayer wiring layer, and includes an interlayer insulating film 34, wiring 35 arranged in multiple layers via the interlayer insulating film 34, electrode pads 36, and vias 37. The vias 37 each connect the semiconductor substrate 21 to the wiring 35, a part of the wiring 35 to another part, or the wiring 35 to one of the electrode pads 36 in the Z-axis direction. Surfaces (in Fig. 4, lower surfaces) of the electrode pads 36 are exposed from the interlayer insulating film 34.

Fig. 4 illustrates a case where the wiring 35 and the electrode pads 36 are three layers of metal M31 to M33. The wiring 35, the electrode pads 36, and the vias 37 contain, for example, copper (Cu) or a Cu alloy. The wiring 35, the electrode pads 36, and the vias 37 may be formed by a single damascene method or a dual damascene method. Furthermore, at least a part of the wiring 35 and at least a subset of the vias 37 may contain aluminum (Al) or an Al alloy, a conductive polysilicon film doped with impurities, or the like.

Bump electrodes 41 and 42 are provided on an opposite side of a surface of the logic board 2 facing the sensor board 1, that is, on the back surface 2b (in Fig. 4, the lower surface) side of the logic board 2. For example, the bump electrodes 41 and 42 are provided on the surfaces (in Fig. 4, the lower surfaces) of the electrode pads 36. The bump electrodes 41 are voltage supply terminals for supplying a power supply voltage (for example, Vdd) or a reference voltage (for example, ground potential (0 V)) to the logic circuits 113. The bump electrodes 42 are signal terminals for inputting or outputting signal to or from the logic circuits 113. The bump electrodes 41 and 42 contain, for example, gold (Au) or solder.

As illustrated in Fig. 4, the semiconductor substrate 21 is provided with vias 51 (examples of a "first via" of the present disclosure) and vias 52 (examples of a "second via" of the present disclosure) penetrating between the front surface 21a (in Fig. 4, the upper surface) of the semiconductor substrate 21 and the back surface 21b located on the opposite side of the front surface 21a. Furthermore, contacts 53 that connect the vias 51 and the wiring 25 are provided on the vias 51. Contacts 54 that connect the vias 52 and the wiring 25 are provided on the vias 52.

The bumps 41 for supplying voltages are connected to the vias 51 via the wiring 35 in the wiring layer 33, and further connected to the wiring 25 via the vias 51 and the contacts 53. The bump electrodes 42 for inputting or outputting signals are connected to the vias 52 via the wiring 35 in the wiring layer 33, and further connected to the wiring 25 via the vias 52 and the contacts 54.

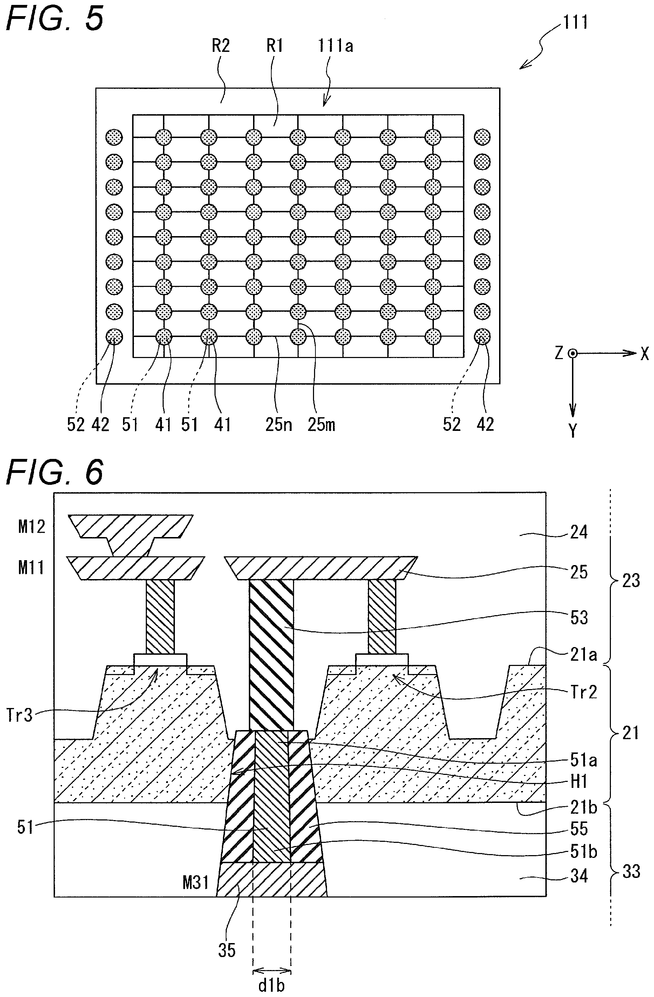

Fig. 5 is a plan view illustrating an arrangement example of the bump electrodes 41 and 42 according to the first embodiment of the present disclosure. Fig. 5 illustrates a front surface 111a side of the multilayer board 111. As illustrated in Figs. 4 and 5, the bump electrodes 41 and the vias 51 are arranged at positions overlapping pixel region R1 in the Z-axis direction. The bump electrodes 41 and the vias 51 are arranged side by side in the X-axis direction (an example of a "first direction" of the present disclosure) and the Y-axis direction (an example of a "second direction" of the present disclosure) in plan view from the Z-axis direction. Furthermore, the bump electrodes 42 and vias 52 are arranged at positions overlapping the peripheral region R2 in the Z-axis direction.

Note that, in Fig. 5, wiring 25n extending in the X-axis direction and wiring 25m extending in the Y-axis direction are part of the wiring 25 connected, via the vias 51 (see Fig. 4) or the like, to the bump electrodes 41 (see Fig. 4) for supplying voltages, and are examples of wiring including any one of the layers of metal M11 to M25. The wiring 25n and the wiring 25m are different layers of metal.

Fig. 6 is a cross-sectional view illustrating a configuration example of each via 51 according to the first embodiment of the present disclosure. As illustrated in Fig. 6, the semiconductor substrate 21 is provided with through holes H penetrating between the front surface 21a and the back surface 21b. An insulating film 55 is provided on an inner surface of each through hole H. As illustrated in Fig. 6, the via 51 is provided in the through hole H via the insulating film 55. One end 51a of the via 51 is connected to the wiring 35, and another end 51b of the via 51 is connected to a corresponding contact 53.

The through hole H1 is formed, for example, from an interlayer insulating film 34 side (in Fig. 6, from a lower side). For this reason, diameter of the through hole H1 tends to be large on the interlayer insulating film 34 side (in Fig. 6, the lower side), and diameter of the via 51 provided in the through hole H1 via the insulating film 55 tend to be large on a side of the ends 51b. Assuming that diameter d1b of the end 51a is defined as the diameter of the via 51, diameter d1b of the via 51 is, for example, larger than or equal to a minimum gate length of the transistors included in the logic circuits 113 and smaller than or equal to 1000 nm, and is, for example, hundreds of nanometers in size.

Since the diameter of the via 51 is smaller than a normal size, the via 51 will also be referred to as a micro-via in the present specification. Furthermore, in the first embodiment, the vias 52 arranged at the positions overlapping the peripheral region R2 in the Z-axis direction also have the same configuration and the same diameter as the vias 51. The vias 52, therefore, will also be referred to as micro-vias.

Note that since the vias 51 and 52 penetrate the semiconductor substrate 21 (for example, a silicon substrate), the vias 51 and 52 may be referred to as through-silicon vias (TSVs). Furthermore, since the vias 51 and 52 have a small diameter and are TSVs, the vias 51 and 52 may be referred to as micro-TSVs. Alternatively, since the vias 51 and 52 have a diameter at a nanometer level and are TSVs, the vias 51 and 52 may be referred to as nTSVs.

The insulating films 55 are, for example, silicon oxide films (SiO2). Conductive films constituting the micro-vias 51 and 52 contain, for example, tungsten (W). The insulating films 55 are provided on the inner surfaces of the through holes H1 to insulate a material (for example, silicon) of the semiconductor substrate 21 from a material (for example, W) of the micro-vias.

Note that, since the through holes H1 in which the micro-vias 51 and 52 are arranged have a high aspect ratio, the insulating films 55 are desirably deposited by a film formation method having a high covering property, such as atomic layer deposition (ALD). The insulating films 55 are deposited with a film thickness of, for example, about 20 nm. Furthermore, the conductive films constituting the micro-vias 51 and 52 are deposited by chemical vapor deposition (CVD). For example, tungsten (W) has good embeddability, and therefore has good embeddability in the through holes H1 having a high aspect ratio.

### (Voltage Supply Routes)

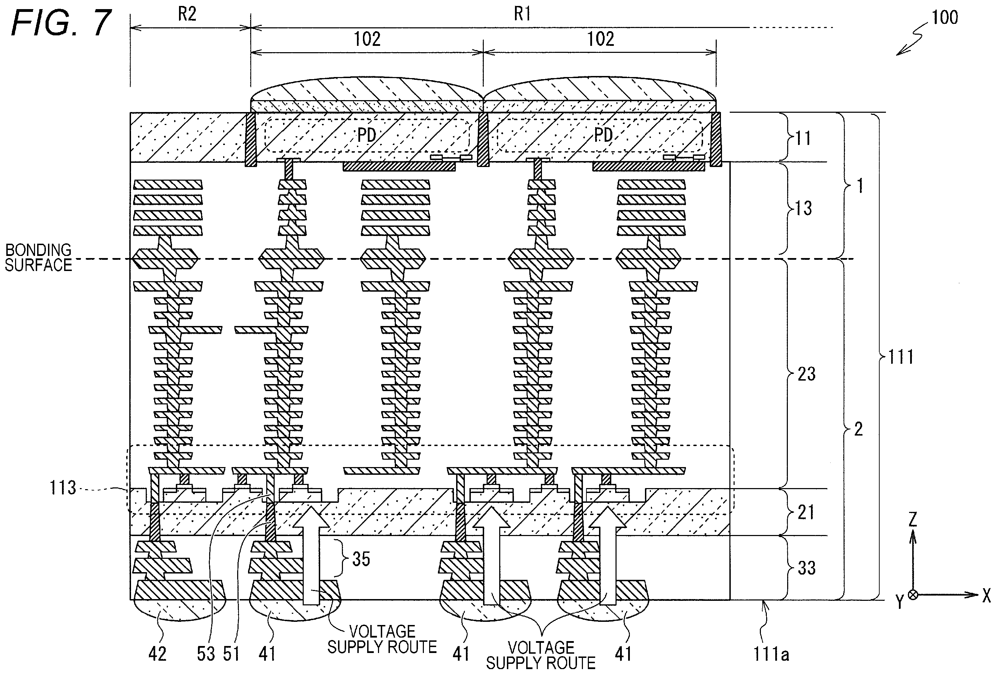

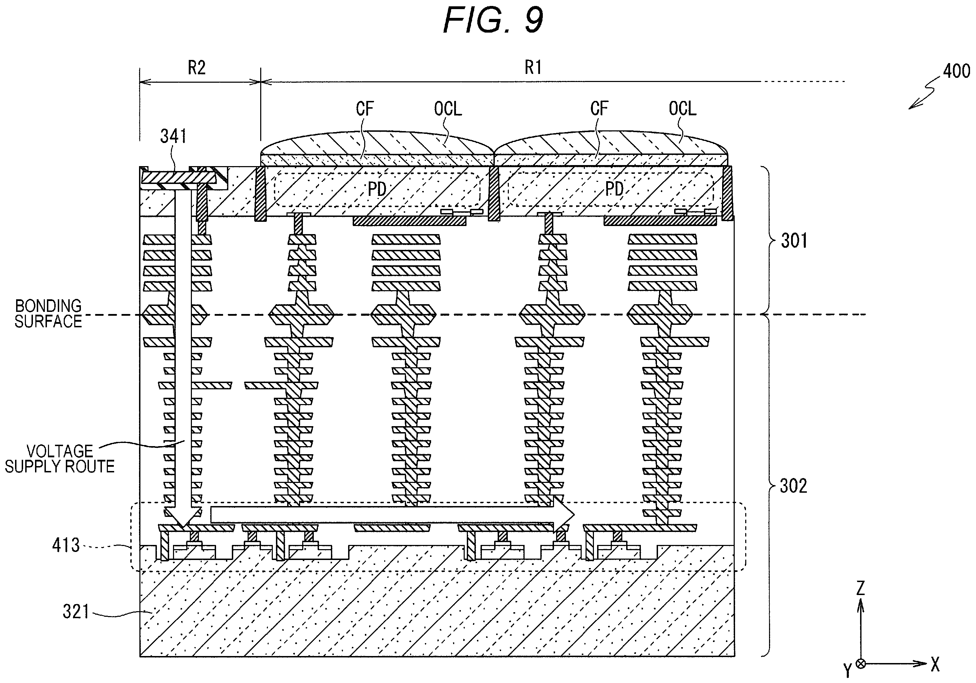

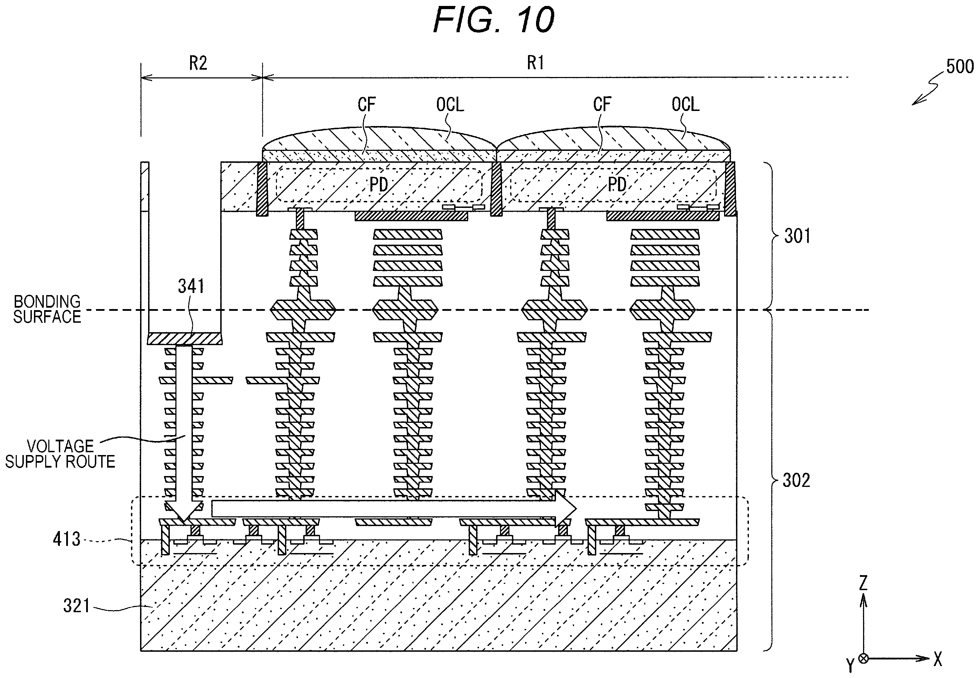

Fig. 7 is a diagram schematically illustrating routes (voltage supply routes) for supplying the power supply voltage or the reference voltage from the bump electrodes 41 for supplying voltages to the logic circuits 113 in the imaging device 100 according to the first embodiment of the present disclosure. As illustrated in Fig. 7, in the imaging device 100, the bump electrodes 41 for supplying voltages are arranged at positions overlapping the pixel region R1 in the Z-axis direction. The power supply voltage or the reference voltage is supplied from the bump electrodes 41 to the logic circuits 113B via the wiring 35, the micro-vias 51, and the contacts 53. In the imaging device 100, the power supply voltage or the reference voltage is supplied from the bump electrodes 41 for supplying voltages to the logic circuits 113 located immediately above the bump electrodes 41. As a result, length of the voltage supply routes (that is, length of wiring for supplying the power supply voltage or the reference voltage) can be shortened as compared with Comparative Examples 1 and 2 (see Figs. 9 and 10) described later.

### (Manufacturing Method)

Next, a method for manufacturing the imaging device 100 illustrated in Fig. 4 will be described. Note that the imaging device 100 is manufactured using various devices such as a film forming device (including a CVD device and a sputtering apparatus), an ion implantation device, a heat treatment device, an etching device, a chemical mechanical polishing (CMP) device, and a bonding device. These devices will be collectively referred to as manufacturing devices.

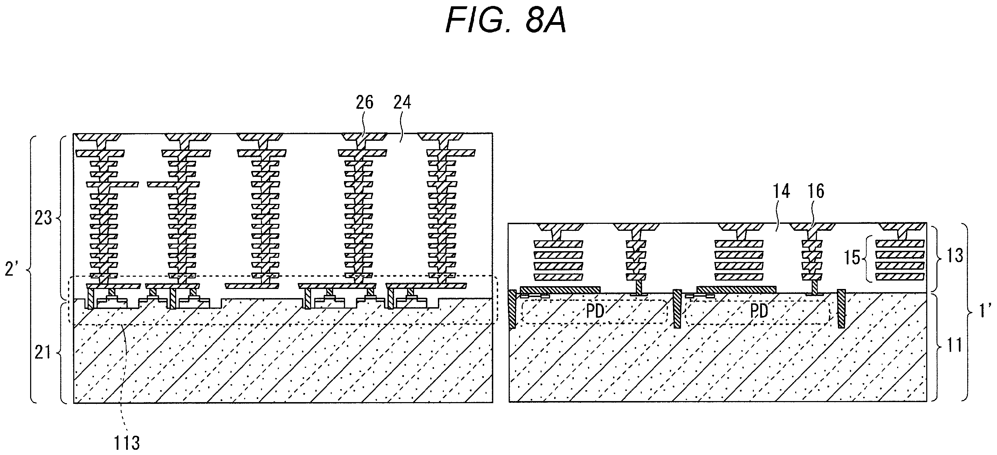

Figs. 8A to 8H are cross-sectional views illustrating the method of manufacturing the imaging device 100 according to the first embodiment of the present disclosure in order of steps. As illustrated in Fig. 8A, the manufacturing devices form a sensor board 1' and a logic board 2' through a CMOS process. The sensor board 1' illustrated on a right side of Fig. 8A is in a state after a surface of the interlayer insulating film 14 is planarized through CMP to expose surfaces of the connection pads 16. The logic board 2' illustrated on the right side of Fig. 8A is a state after the surface of the interlayer insulating film 24 is planarized through CMP to expose the surfaces of the connection pads 26.

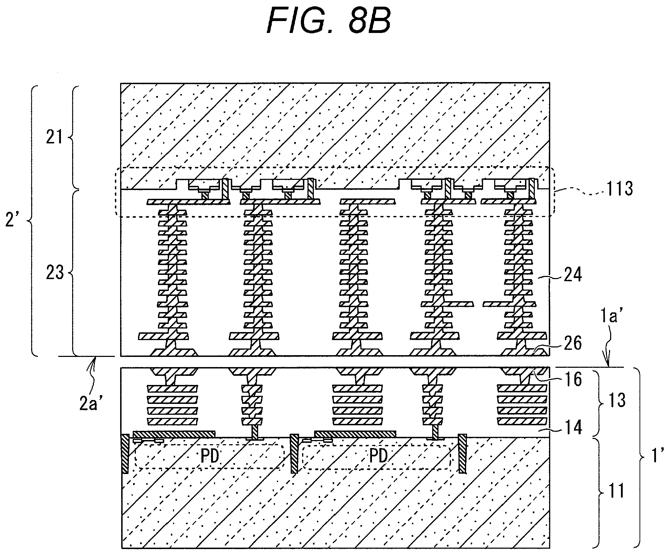

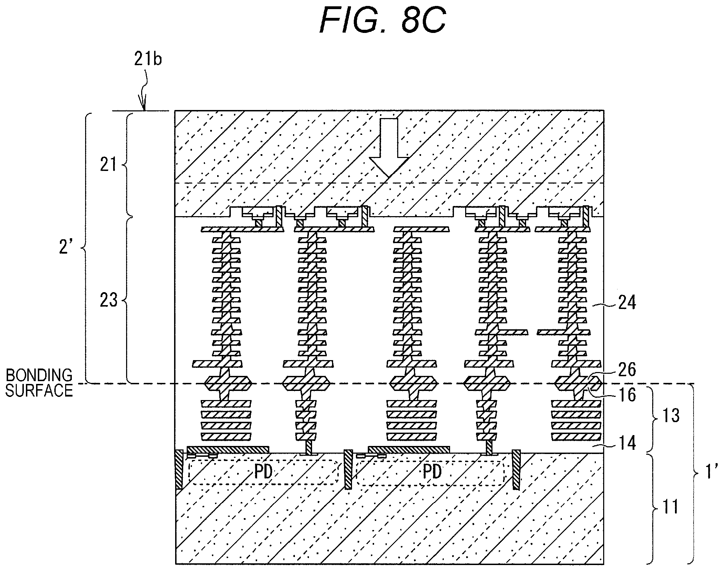

Next, as illustrated in Fig. 8B, the manufacturing devices make a surface 1a' side of the sensor board 1' and a surface 2a' side of the logic board 2' face each other. As illustrated in Fig. 8C, the manufacturing devices then bond the sensor board 1' and the logic board 2' together. In this bonding step, the manufacturing devices bring the interlayer insulating film 14 of the sensor board 1 and the interlayer insulating film 24 of the logic board 2 into close contact with each other, bring the connection pads 16 of the sensor board 1 and the connection pads 26 of the logic board 2 into close contact with each other, and perform heat treatment. As a result, the interlayer insulating films 14 and 24 are bonded to each other and the connection pads 16 and 26 are bonded to each other, so that the sensor board 1' and the logic board 2' are integrated together.

Next, the manufacturing devices grind a back surface 21b side of the semiconductor substrate 21 to thin the semiconductor substrate 21 (that is, thickness is reduced). Foiling of the semiconductor substrate 21 is performed through CMP.

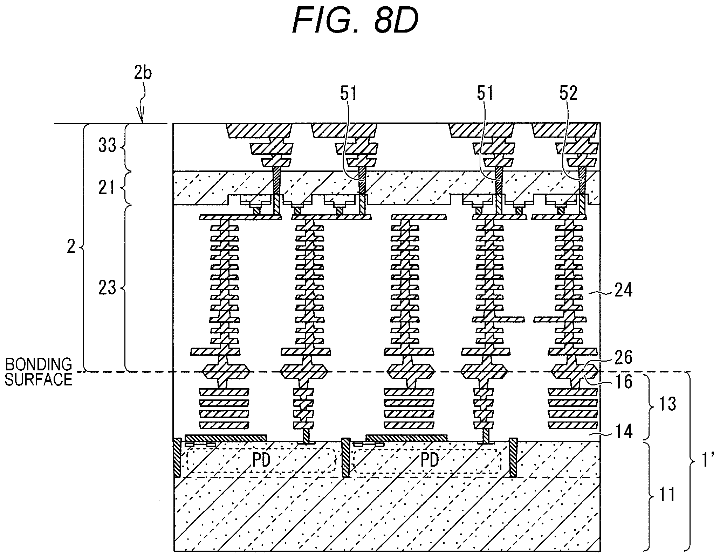

Next, as illustrated in Fig. 8D, the manufacturing devices form the micro-vias 51 and 52 and the wiring layer 33 connected to the micro-vias 51 and 52 in this order on the back surface 21b side of the foiled semiconductor substrate 21. As a result, the logic board 2 illustrated in Fig. 4 is completed.

In a step of Fig. 8D, the sensor board 1' functions as a support board supporting the logic board 2'. Since the back surface 1b' of the sensor board 1' used as the support board is ground and removed in a later step, there is no problem even if the back surface 1b' comes into contact with the manufacturing devices or the like and some scratches occur in this step.

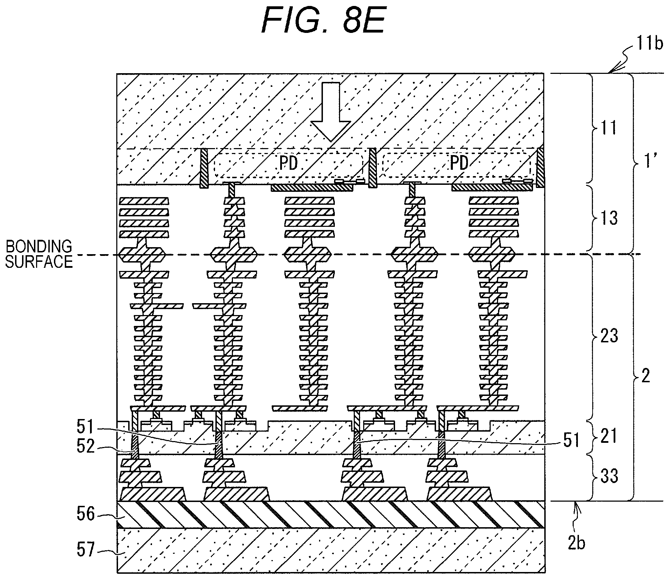

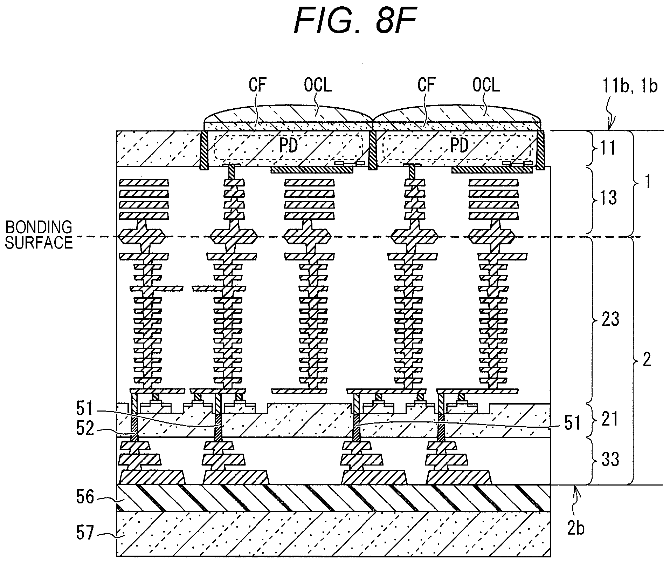

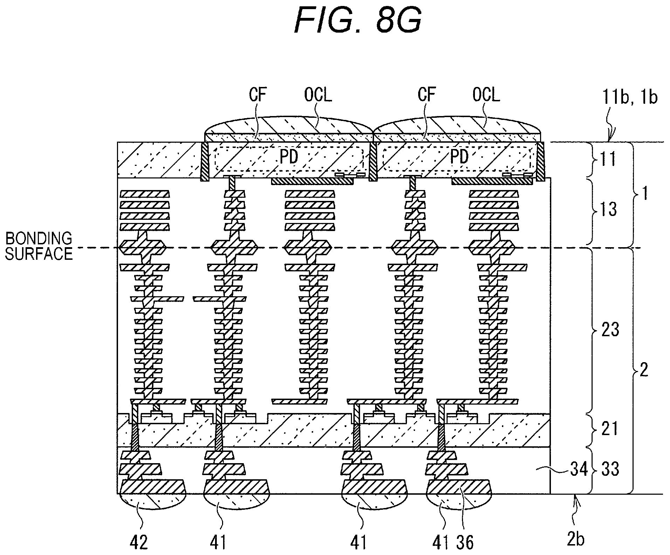

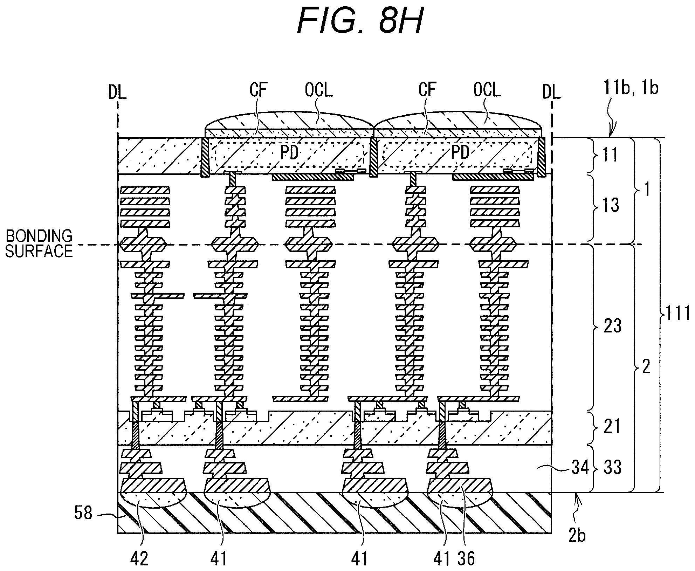

Furthermore, the sensor board 1' and the logic board 2' are integrated together in the bonding process of Fig. 8C. As a result, for example, the logic board 2' can be fixed more firmly than in a case where the logic board 2' is processed in a state where the logic board 2' is bonded to the support board via a resin adhesive sheet or the like. Since the through holes H1 (see Fig. 8) can be formed in the semiconductor substrate 21 in a state where the logic board 2' is firmly fixed and formation and patterning of a conductive film of tungsten (W) or the like can be performed, the micro-vias 51 and 52 can be formed with high processing accuracy.

Furthermore, since a resin adhesive sheet or the like is not used to fix the logic board 2', it is possible to use, for example, a process in which maximum temperature is about 400°C in a case where the micro-vias 51 and 52 and the wiring layer 33 are formed. It is possible to broaden a selection range of the process.

Next, as illustrated in Fig. 8E, the manufacturing devices attach (temporarily bond) a support board 57 to the back surface 2b (in Fig. 8E, the lower surface) side of the logic board 2 via an adhesive sheet 56. Next, the manufacturing devices grind the back surface 11b (in Fig. 8E, the upper surface) side of the semiconductor substrate 11 to thin the semiconductor substrate 11. Foiling of the semiconductor substrate 11 is performed through CMP. The sensor board 1 illustrated in Fig. 4 is thus completed.

Next, as illustrated in Fig. 8F, the manufacturing devices form the color filters CF on the back surface 11b of the foiled semiconductor substrate 11, that is, on the back surface 1b (in Fig. 8F, the upper surface) of the sensor board 1. Next, the manufacturing devices form the on-chip lenses OCL on the color filter CF. Although not illustrated, protective films may be formed between the semiconductor substrate 11 and the color filters CF and between the color filters CF and the on-chip lenses OCL. After forming the on-chip lenses OCL, the manufacturing devices peel off the adhesive sheet 56 and the support board 57 from the back surface 2b side of the logic board 2.

Next, as illustrated in Fig. 8G, the manufacturing devices form the bump electrodes 41 for supplying voltages and the bump electrodes 42 for inputting and outputting signals on the back surface 2b side of the logic board 2.

Next, as illustrated in Fig. 8H, the manufacturing devices attach the protective sheet 58 to the back surface 2b side of the logic board 2. The manufacturing devices then dice (divide into pieces) the multilayer board 111 including the sensor board 1 and the logic board 2 along dicing lines DL. After the dicing, the multilayer boards 111 (chips) obtained as a result of the division are peeled off from the protective sheet 58. Through such steps, the imaging device 100 illustrated in Fig. 4 is completed.

### (Effects of First Embodiment)

As described above, the imaging device 100 according to the first embodiment of the present disclosure includes the sensor board 1 including the pixel region R1 in which the plurality of pixels 102 that performs photoelectric conversion is arranged side by side, the logic board 2 that is bonded to one surface side of the sensor board 1 and that includes the logic circuits 113 that process signals input to the sensor board 1 or signals output from the sensor board 1, and the bump electrodes 41 that are provided on the logic board 2 on an opposite side (for example, the back surface 2b side of the logic board 2) of the surface facing the sensor board 1 and that supply the power supply voltage or the reference voltage to the logic circuits 113. At least a subset of the bump electrodes 41 is arranged at a position overlapping the pixel region R1 in the thickness direction (for example, in the Z-axis direction) of the multilayer board 111 including the sensor board 1 and the logic board 2.

According to this, at the position overlapping in the Z-axis direction, the power supply voltage or the reference voltage is supplied from the back surface 2b side of the logic board 2 to the logic circuits 113 located immediately above the back surface 2b. As in Comparative Examples 1 and 2 described later, the imaging device 100 can shorten the voltage supply routes and length of wiring to which voltages are applied, as compared with a case where the power supply voltage or the reference voltage is supplied from a peripheral region of the sensor board. As a result, the imaging device 100 can suppress IR drop (voltage drop) and, for example, easily keep voltages applied to elements (for example, MOS transistors Tr2 to Tr4) included in the logic circuits 113 constant. As a result, the imaging device 100 can suppress deterioration of device characteristics due to IR drop.

### (Comparative Examples)

### (1) Comparative Example 1

Fig. 9 is a cross-sectional view illustrating configuration of an imaging device 400 according to Comparative Example 1 of the present disclosure. As illustrated in Fig. 9, the imaging device 400 according to Comparative Example 1 includes a sensor board 301 including photodiodes PD and a logic board 302 bonded to one surface (in Fig. 9, a lower surface) side of the sensor board 301. In the imaging device 400 according to Comparative Example 1, a bonding pad 341 for supplying power is provided on an uppermost surface of the sensor board 301. Although not illustrated, a gold wire or the like is wire-bonded to the bonding pad 341.

In the imaging device 400, as indicated by arrows in Fig. 9, a power supply voltage is supplied from the bonding pad 341 to logic circuits 413 provided on a semiconductor substrate 321 via a large number of wires in the sensor board 301 and the logic board 302. Furthermore, since the bonding pad 341 is arranged in the peripheral region R2, the power supply voltage is supplied from the peripheral region R2 to the logic circuits 413 arranged at positions overlapping the pixel region R1 in the Z-axis direction. In Comparative Example 1, therefore, routes (voltage supply routes) for supplying the power supply voltage or the reference voltage are long, and IR drop is likely to occur.

Furthermore, the wire bonded to the bonding pad 341 has a small diameter and a loop height. The smaller the diameter of the wire, and the longer the wire, the higher a resistance value of the wire, so that IR drop is more likely to occur.

### (2) Comparative Example 2

Fig. 10 is a cross-sectional view illustrating configuration of an imaging device 500 according to Comparative Example 2 of the present disclosure. As illustrated in Fig. 10, in the imaging device 500 according to Comparative Example 2, a bonding pad 341 for supplying power is provided on an uppermost surface of a logic board 302. Although not illustrated, in Comparative Example 2, as in Comparative Example 1, a gold wire or the like is wire-bonded to the bonding pad 341.

In the imaging device 500, too, as indicated by arrows in Fig. 10, a power supply voltage is supplied from the bonding pad 341 to logic circuits 413 provided on a semiconductor substrate 321 via a large number of wires in the logic board 302. Furthermore, since the bonding pad 341 is arranged in the peripheral region R2, the power supply voltage is supplied from the peripheral region R2 to the logic circuits 413 arranged at positions overlapping the pixel region R1 in the Z-axis direction. As a result, in Comparative Example 2, too, voltage supply routes are long, and IR drop is likely to occur. Furthermore, since the bonding pad 341 is wire-bonded, IR drop is more likely to occur as diameter of the wire becomes smaller and the wire becomes longer.

### (Modifications of First Embodiment)

### (1) First Modification

In the above embodiment, it has been described that the micro-vias 51 and 52 are connected to the wiring 25 via the contacts 53 and 54. In the embodiment of the present disclosure, however, the micro-vias 51 and 52 may be directly connected to the wiring 25.

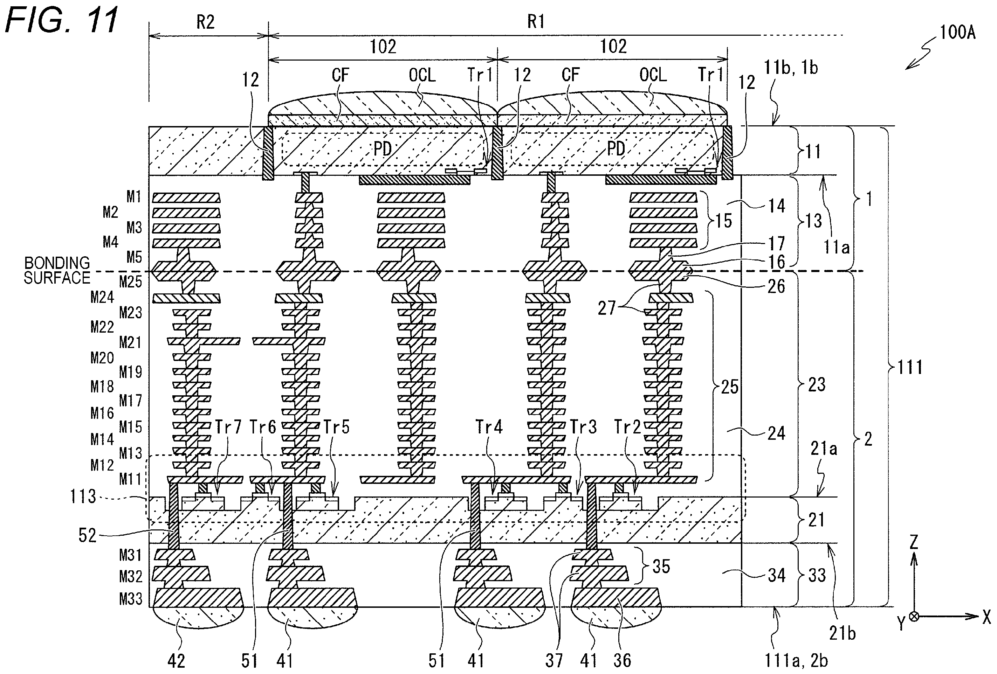

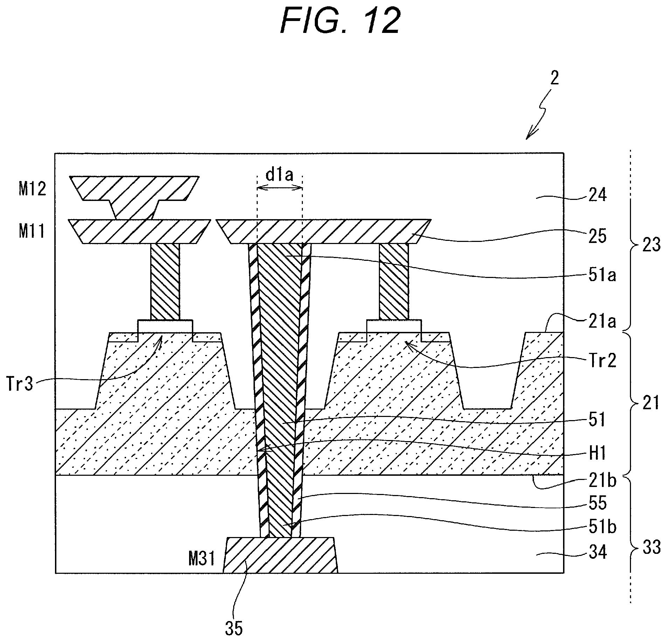

Fig. 11 is a cross-sectional view illustrating configuration of an imaging device 100A according to a first modification of the first embodiment of the present disclosure. Fig. 12 is a cross-sectional view illustrating the micro-vias 51 of the imaging device 100A according to the first modification of the first embodiment of the present disclosure. In the imaging device 100A according to the first modification of the first embodiment, the micro-vias 51 connected to the bump electrodes 41 for supplying voltages and the micro-vias 52 connected to the bump electrodes 42 for inputting and outputting signals are directly connected to the wiring 25 without interposing the contacts 53 and 54. Even with such a configuration, the same effects as those produced by the imaging device 100 according to the first embodiment described above are produced.

Furthermore, although the through holes H1 are formed from the interlayer insulating film 34 side in the first embodiment, the first embodiment is not limited to this. For example, in Fig. 12, the through holes H1 may be formed from an interlayer insulating film 24 side (in Fig. 12, the upper side), and the diameter of the through holes H1 may be formed in such a way as to be larger on the interlayer insulating film 24 side.

Diameter of the micro-vias 51 provided in the through holes H1 via the insulating film 55 may also be formed in such a way as to be larger on the side of the ends 51a connected to the wiring 25. In this case, diameter d1a of the ends 51a may be the diameter of the micro-vias 51. The diameter d1a of the micro-vias 51 is, for example, larger than or equal to the minimum gate length of the transistors included in the logic circuits 113 and smaller than or equal to 1000 nm, and is, for example, hundreds of nanometers in size. Note that, although not illustrated in Fig. 12, the micro-vias 52 arranged at the positions overlapping the peripheral region R2 in the Z-axis direction may also have the configuration according to the first modification as with the micro-vias 51.

In the imaging device 100 A, too, as illustrated in Fig. 12, the power supply voltage or the reference voltage is supplied to the logic circuits 113 from the positions on the back surface 2b side of the logic board 2 overlapping the pixel region R1 in the Z-axis direction. As a result, since the imaging device 100A can shorten the voltage supply routes as compared with Comparative Examples 1 and 2, the same effects as those produced by the imaging device 100 according to the first embodiment described above can be produced.

### (2) Second Modification

In the first embodiment described above, it has been described that the bump electrodes 41 for supplying voltages are arranged at the positions overlapping the pixel region R1 and the bump electrodes 42 for inputting and outputting signals are arranged at the positions overlapping the peripheral region R2 in the thickness direction (for example, in the Z-axis direction) of the multilayer board 111. In the first embodiment of the present disclosure, however, the bump electrodes 41 and 42 are not limited to this. In the embodiment of the present disclosure, for example, a subset of the bump electrodes 41 for supplying voltages may be arranged at positions overlapping the peripheral region R2, and a subset of the bump electrodes 42 for transmitting and receiving signals may be arranged at positions overlapping the pixel region R1 in accordance with the arrangement of the logic circuits or the like.

Even with such a configuration, the power supply voltage or the reference voltage is supplied from the back surface 2b side of the logic board 2 to the logic circuits 113. As a result, the voltage supply routes to the logic circuits 113 can be shortened, and IR drop can be suppressed.

### (3) Third Modification

Although it has been described in the first embodiment that a plurality of pixel transistors is provided on the sensor board 1, the embodiment of the present disclosure is not limited to this. In the embodiment of the present disclosure, a subset of the pixel transistors may be provided on the logic board 2, instead. For example, among the pixel transistors, the amplification transistor AMP may be provided on the logic board 2, and the other transistors may be provided on the sensor board 1. Alternatively, among the pixel transistors, the transfer transistor TR may be provided on the sensor board 1, and the other transistors may be provided on the logic board 2.

### <Second Embodiment>

In the first embodiment described above, a case where the logic board 2 is one semiconductor substrate 21 has been described. In embodiments of the present disclosure, however, the number of semiconductor substrates constituting the logic board 2 is not limited to one. The logic board 2 may include a plurality of semiconductor substrates, instead.

### (Configuration Example)

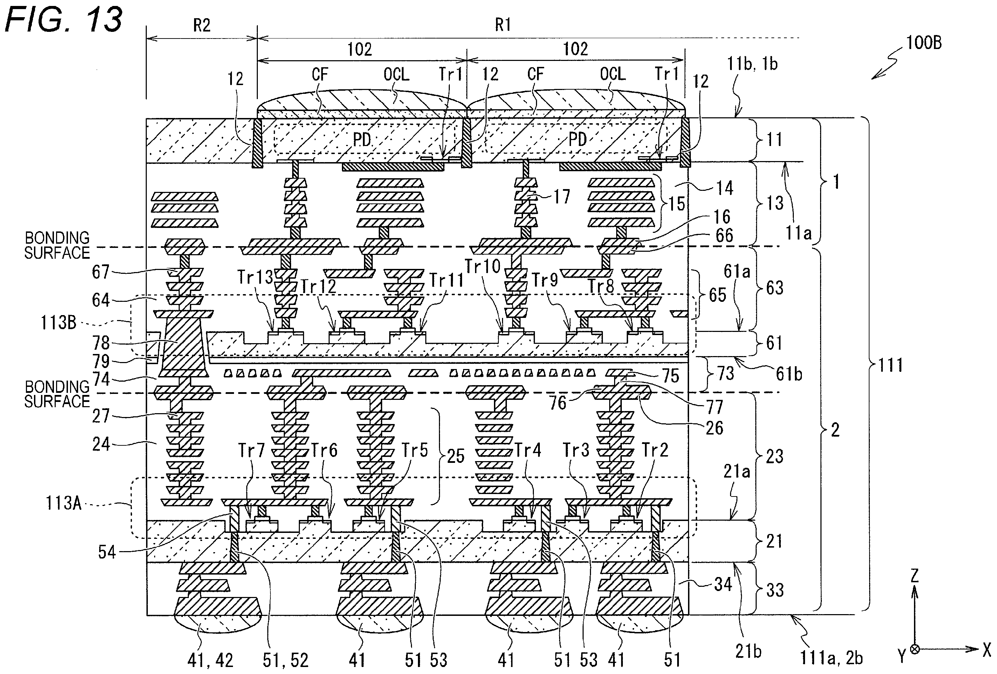

Fig. 13 is a cross-sectional view illustrating a configuration example of an imaging device 100B according to a second embodiment of the present disclosure. As illustrated in Fig. 13, in an imaging device 100B according to the second embodiment, a logic board 2 includes a semiconductor substrate 21 provided with logic circuits 113A and a semiconductor substrate 61 (an example of a "third semiconductor layer" of the present disclosure) provided with logic circuits 113B. In the imaging device 100B, the logic circuits 113 illustrated in Fig. 1 include the logic circuits 113 A and the logic circuits 113B.

Fig. 13 illustrates n-channel or p-channel MOS transistors Tr2 to Tr7 as some of the plurality of MOS transistors constituting the logic circuits 113A. Furthermore, Fig. 13 illustrates n-channel or p-channel MOS transistors Tr2 to Tr7 as some of the plurality of MOS transistors constituting the logic circuits 113B.

The semiconductor substrate 61 has a front surface 61a (an example of a "third surface" of the present disclosure) facing the sensor board 1 and a back surface 61b (an example of a "fourth surface" of the present disclosure) located on an opposite side of the front surface 61a. A wiring layer 63 (an example of a "fourth wiring layer" of the present disclosure) is arranged on a front surface 61a side of the semiconductor substrate 61, and a wiring layer 73 (an example of a "fifth wiring layer" of the present disclosure) is arranged on a back surface 61b side of the semiconductor substrate 61.

The wiring layer 63 on the front surface 61a side is a multilayer wiring layer, and includes an interlayer insulating film 64, wiring 65 arranged in multiple layers with the interlayer insulating film 64 interposed therebetween, connection pads 66 (an example of a "part of a conductor included in a fourth wiring layer" of the present disclosure), and vias 67. The vias 67 each connect the semiconductor substrate 61 to the wiring 65, a part of the wiring 65 to another part, or the wiring 65 to one of the connection pads 66 in the thickness direction (for example, in the Z-axis direction) of the multilayer board 111. The connection pads 66 face the bonding surface between the sensor board 1 and the logic board 2. Surfaces (in Fig. 13, upper surfaces) of the connection pads 66 are exposed from the interlayer insulating film 64.

The wiring 65, the connection pads 66, and the vias 67 contain, for example, copper (Cu) or a Cu alloy. The wiring 65, the connection pads 66, and the vias 67 may be formed by a single damascene method or a dual damascene method. Furthermore, at least a part of the wiring 65 and at least a subset of the vias 67 may contain aluminum (Al), an Al alloy, a conductive polysilicon film doped with impurities, or the like.

The wiring layer 73 on the back surface 61b side is a single layer or a multilayer wiring layer, and includes an interlayer insulating film 74, wiring 75, connection pads 76 (an example of "a part of a conductor included in a fifth wiring layer" of the present disclosure), and vias 77. The vias 77 each connect a part of the wiring 75 to another part or the wiring 75 to one of the connection pads 76 in the Z-axis direction. Surfaces (in Fig. 13, lower surfaces) of the connection pads 76 are exposed from the interlayer insulating film 74.

The wiring 75, the connection pads 76, and the vias 77 contain, for example, copper (Cu) or a Cu alloy. The wiring 75, the connection pads 76, and the vias 77 may be formed by a single damascene method or a dual damascene method. Furthermore, at least a part of the wiring 75 and at least a subset of the vias 77 may contain aluminum (Al), an Al alloy, a conductive polysilicon film doped with impurities, or the like.

In the imaging device 100B, the interlayer insulating films 24 and 74 are bonded to each other, and the connection pads 26 and 76 are bonded to each other. As a result, in the logic board 2, a lower board including the semiconductor substrate 21 and an upper board including the semiconductor substrate 61 are integrated together. Furthermore, the interlayer insulating films 64 and 14 are bonded to each other, and the connection pads 66 and 16 are bonded to each other, so that the sensor board 1 and the logic board 2 are integrated together.

Furthermore, the semiconductor substrate 61 is provided with vias 78 (examples of a "fourth via" of the present disclosure) that penetrate between the front surface 61a and the back surface 61b of the semiconductor substrate 61 and connect the wiring 65 on the front surface 61a side and the wiring 75 on the back surface 61b side to each other. The vias 78 are arranged at positions overlapping the peripheral region R2 in the Z-axis direction.

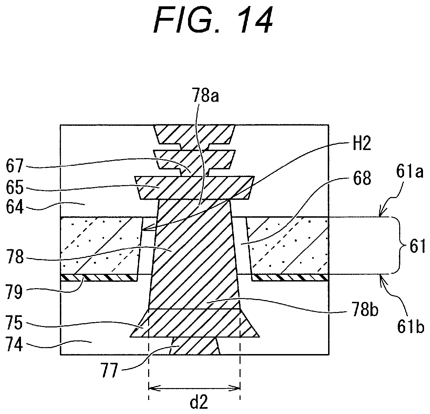

Fig. 14 is a cross-sectional view illustrating a configuration example of each via 78 according to the second embodiment of the present disclosure. As illustrated in Fig. 14, the semiconductor substrate 61 is provided with through holes H2 penetrating between the front surface 61a and the back surface 61b. An insulating film 68 is provided on an inner surface of each through hole H2. As illustrated in Fig. 14, each via 78 is provided in the through hole H2 via the insulating film 68. One end 78a of each micro-via 51 is connected to the wiring 65, and another end 78b of the via 78 is connected to the wiring 75.

The through holes H2 are formed, for example, from an interlayer insulating film 74 side (in Fig. 14, from a lower side). For this reason, diameter of the through holes H2 tends to be large on the interlayer insulating film 74 side (in Fig. 14, the lower side), and diameter of the vias 78 provided in the through holes H2 via the insulating films 68 tend to be large on a side of the ends 78b. Assuming that diameter d2 of the ends 78b is defined as the diameter of the vias 78, the diameter d2 of the vias 78 is sufficiently larger than the diameter d1b of the micro-vias 51 illustrated in Fig. 6 and the diameter d1a of the micro-vias 51 illustrated in Fig. 12, and is, for example, several micrometers in size.

Note that since the vias 78 penetrate the semiconductor substrate 61 (for example, a silicon substrate), the vias 78 may be referred to as through-silicon vias (TSVs).

### (Voltage Supply Routes)

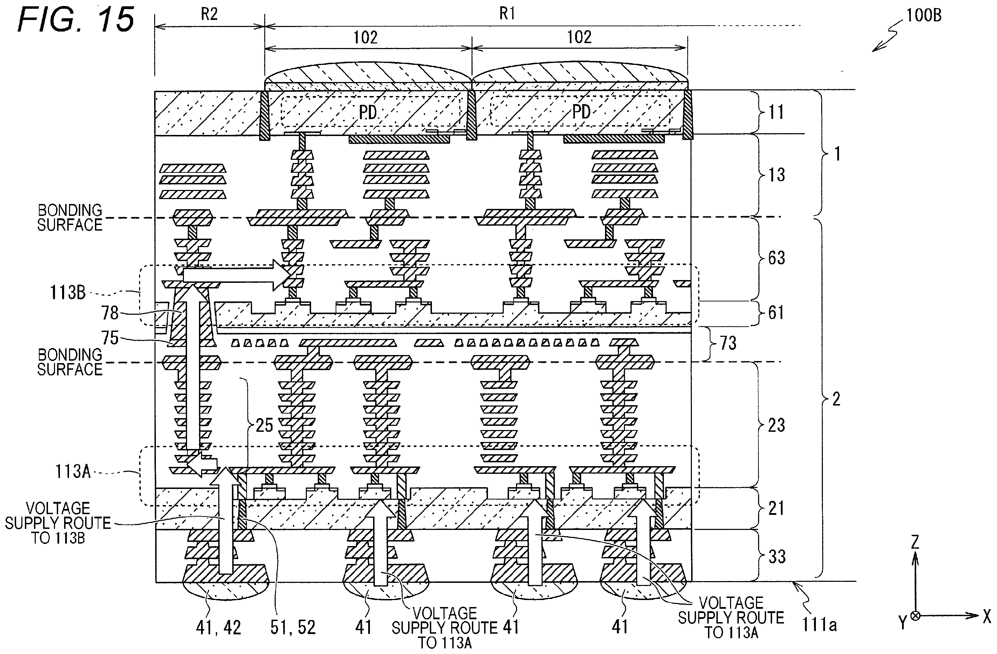

Fig. 15 is a diagram schematically illustrating voltage supply routes of the imaging device 100B according to the second embodiment of the present disclosure. As illustrated in Fig. 15, in the imaging device 100B, bump electrodes 41 for supplying voltages are arranged in addition to bump electrodes 42 for transmitting and receiving signals at positions overlapping the peripheral region R2 in the Z-axis direction. Similarly, in addition to the micro-vias 52 for transmitting and receiving signals, the micro-vias 51 for supplying voltages are arranged at positions overlapping the peripheral region R2 in the Z-axis direction. The vias 78 are connected to the bump electrodes 41 and the micro-vias 51 for supplying voltages arranged at positions overlapping the peripheral region R2 in the Z-axis direction via the wirings 25 and 75 and the like.

As illustrated in Fig. 15, routes ("voltage supply routes A to 113B" hereinafter) for supplying the power supply voltage or the reference voltage from the bump electrodes 41 arranged at the positions overlapping the peripheral region R2 in the Z-axis direction to the logic circuits 113B via the wirings 25 and 75 and the vias 78 are provided. In the imaging device 100B, the power supply voltage or the reference voltage can be supplied to the logic circuits 113B via the "voltage supply routes A to 113B".

### (Effects of Second Embodiment)

As described above, the imaging device 100B according to the second embodiment of the present disclosure includes, as the logic circuits 113 illustrated in Fig. 1, the logic circuits 113A provided on the semiconductor substrate 21 and the logic circuits 113B provided on the semiconductor substrate 61. The power supply voltage or the reference voltage is supplied to the logic circuits 113A from the positions on the back surface 2b side of the logic board 2 overlapping the pixel region R1 in the Z-axis direction. As a result, the imaging device 100B can shorten the voltage supply routes to the logic circuits 113A and suppress IR drop.

Furthermore, the power supply voltage or the reference voltage is supplied to the logic circuits 113B from the positions on the back surface 2b side of the logic board 2 overlapping the peripheral region R2 in the Z-axis direction. The voltage supply routes to the logic circuits 113B, therefore, tend to be longer than in the case of the logic circuits 113A. Similarly to the logic circuits 113A, however, the voltages are supplied to the logic circuits 113B not through a wire such as a gold wire but through the bump electrodes 41. As a result, resistance values of the voltage supply routes to the logic circuits 113B can be reduced as compared with the case where the voltages are supplied via the wire as in Comparative Examples 1 and 2, so that IR drop can be suppressed.

As described above, the imaging device 100B can suppress IR drop, and, for example, it becomes easy to keep voltages applied to elements (for example, MOS transistors Tr2 to Tr4) included in the logic circuits 113 A and voltages applied to elements (for example, MOS transistors Tr8 to Tr13) included in the logic circuits 113B constant. As a result, the imaging device 100B can suppress deterioration of device characteristics due to IR drop.

### (Modifications of Second Embodiment)

### (1) First Modification

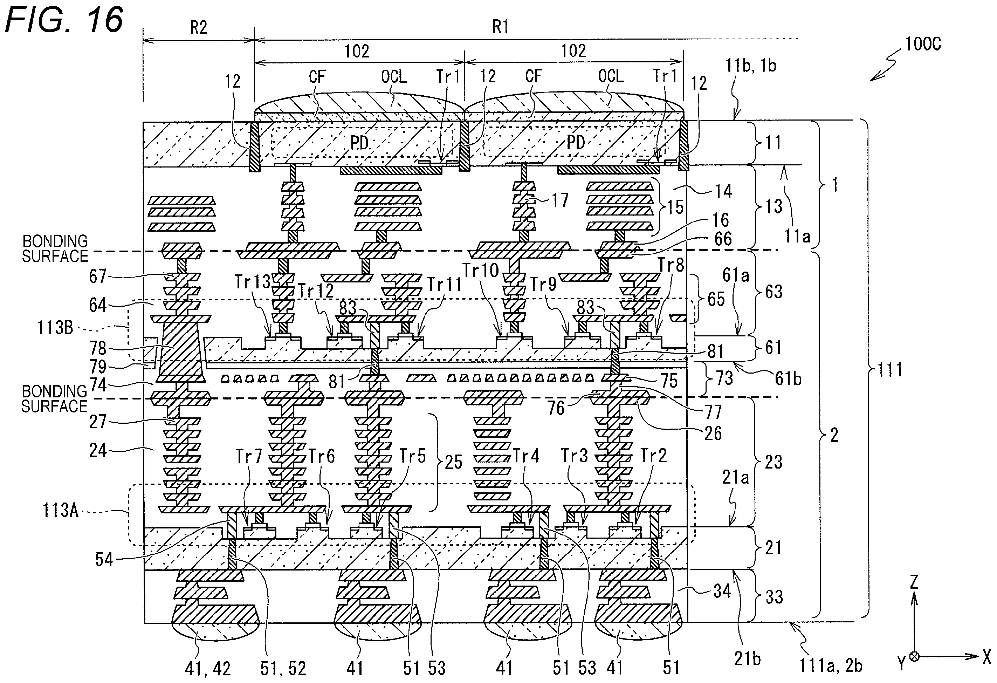

In the embodiment of the present disclosure, micro-vias for supplying voltages may be provided not only in the semiconductor substrate 21 but also in the semiconductor substrate 61. Fig. 16 is a cross-sectional view illustrating configuration of an imaging device 100C according to a first modification of the second embodiment of the present disclosure. As illustrated in Fig. 16, in the imaging device 100C according to the first modification of the second embodiment, micro-vias 81 for supplying voltages (examples of a "third via" of the present disclosure) are provided in the semiconductor substrate 61. The micro-vias 81 penetrate between the front surface 61a and the back surface 10b of the semiconductor substrate 61. The micro-vias 81 are connected to the contacts 83, and connect the wiring 65 on the front surface 61a side and the wiring 75 on the back surface 61b side via the contacts 83.

Configuration and diameters of the micro-vias 81 and the contacts 83 are the same as the configuration of the micro-vias 51 and the contacts 53. The diameter of the micro-vias 81 is larger than or equal to a minimum gate length of the transistors included in the logic circuits 113B and smaller than or equal to 1000 nm, and is, for example, hundreds of nanometers in size.

The micro-vias 81 are TSVs as with the micro-vias 51 and may be referred to as micro-TSVs, or may be referred to as nTSVs because the diameter thereof is at a nanometer level.

The micro-vias 81 are arranged at positions overlapping the pixel region R1 in the thickness direction (for example, in the Z-axis direction) of the multilayer board 111. In a case where the diameter of the vias 78 arranged at the positions overlapping the peripheral region R2 in the Z-axis direction is compared with the diameter of the micro-vias 81, the diameter of the vias 78 is larger than the diameter of the micro-vias 81.

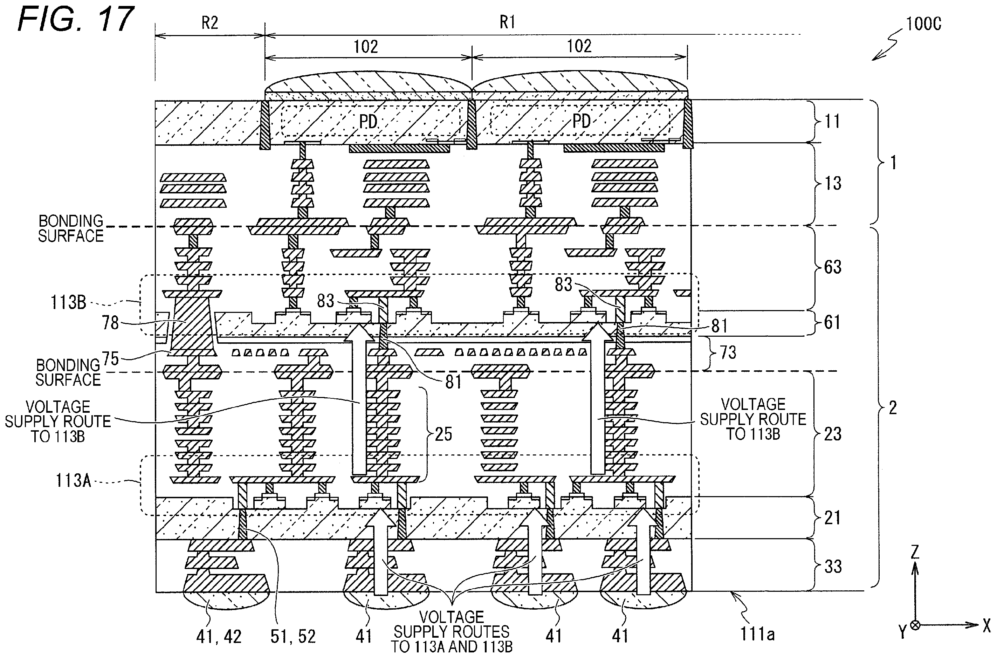

Fig. 17 is a diagram schematically illustrating voltage supply routes of the imaging device 100C according to the first modification of the second embodiment of the present disclosure. As illustrated in Fig. 17, in the imaging device 100C, routes ("voltage supply routes B to 113B" hereinafter) for supplying the power supply voltage or the reference voltage from the bump electrodes 41 arranged at the positions overlapping the pixel region R1 in the Z-axis direction to the logic circuits 113B via the wiring 75, the micro-vias 81, and the contacts 83 are provided. In the imaging device 100C, the power supply voltage or the reference voltage is supplied to the logic circuits 113B via the "voltage supply routes B to 113B".

According to this, the power supply voltage or the reference voltage is supplied to not only the logic circuits 113A but also the logic circuits 113B from the positions on the back surface 2b side of the logic board 2 overlapping the pixel region R1 in the Z-axis direction. Since the imaging device 100C can shorten the voltage supply routes to the logic circuits 113B, it is possible to further suppress IR drop.

Note that, in the imaging device 100C, the "voltage supply routes A to 113B" illustrated in Fig. 15 may also be provided. The imaging device 100C can further reduce the resistance values of the voltage supply routes to the logic circuit 113B by including both the "voltage supply routes A to 113B" and the "voltage supply routes B to 113B".

### (2) Second Modification

In the embodiment of the present disclosure, the diameter of the vias arranged at the positions overlapping the peripheral region R2 in the Z-axis direction may be larger than the diameter of the micro-vias 51 arranged at the positions overlapping the pixel region R1 in the Z-axis direction.

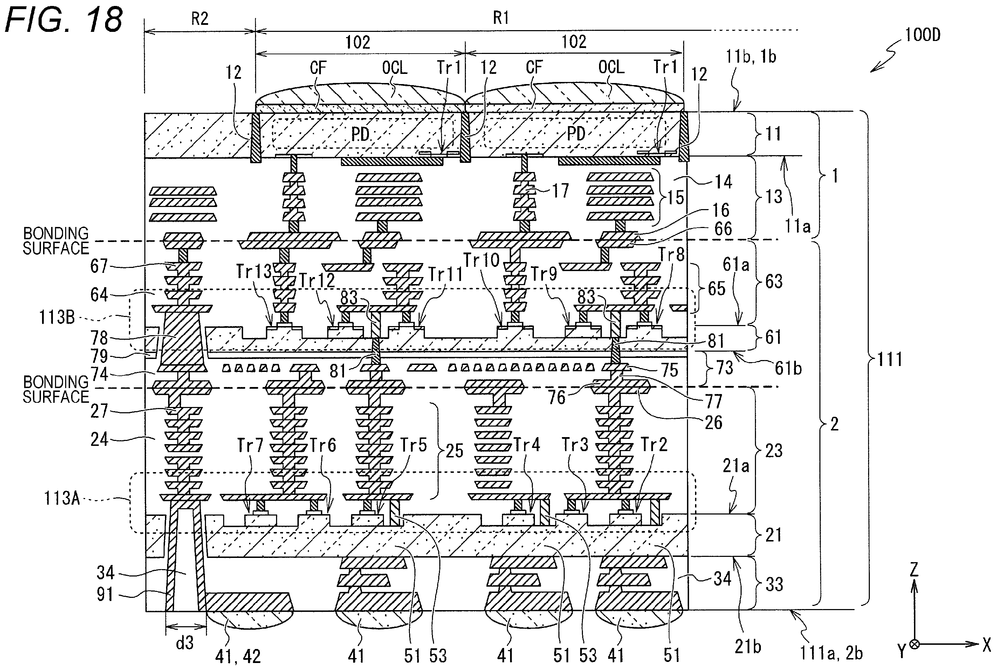

Fig. 18 is a cross-sectional view illustrating configuration of an imaging device 100D according to a second modification of the second embodiment of the present disclosure. As illustrated in Fig. 18, in the imaging device 100D according to the second modification of the second embodiment, vias 91 penetrating between the front surface 21a and the back surface 21b of the semiconductor substrate 21 are arranged at positions overlapping the peripheral region R2 in the Z-axis direction. One end of each via 91 is connected to the bump electrode 41 for supplying voltages arranged in the peripheral region. Another end of the via 91 is connected to the wiring 25 on the front surface 12a side of the semiconductor substrate 21. Furthermore, one end of another via 91 may be connected to the bump electrode 42 for transmitting and receiving signals arranged in the peripheral region R2, and another end may be connected to the wiring 25 on the front surface 12a side of the semiconductor substrate 21.

The vias 91 are formed from the back surface 21b side toward the front surface 21a side of the semiconductor substrate 21. Diameter of the vias 91, therefore, is formed in such a way as to be larger on the back surface 21b side (in Fig. 18, a lower side) than on the front surface 21a side of the semiconductor substrate 21. When diameter d3 at an end of each via 91 on the back surface 21b side is defined as diameter of the via 91, the diameter d3 of the via 91 is sufficiently larger than the diameter (for example, d1b illustrated in Fig. 6 and d1a illustrated in Fig. 12) of the micro-via 51, and is, for example, several micrometers in size As a result, resistance of the vias 91 arranged in the peripheral region R2 can be suppressed to be lower than that of the micro-vias 51 arranged in the pixel region R1.

Note that since the vias 91 penetrate the semiconductor substrate 21 (for example, a silicon substrate), the vias 91 may be referred to as through-silicon vias (TSVs).

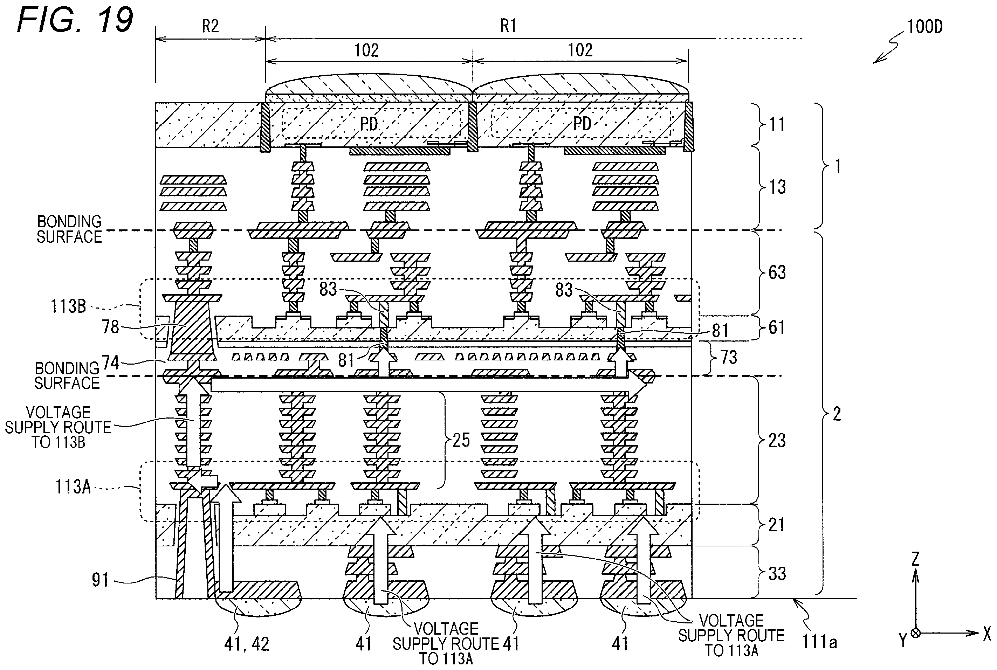

Fig. 19 is a diagram schematically illustrating voltage supply routes to the logic circuits 113A and 113B in the imaging device 100C according to the second modification of the second embodiment of the present disclosure. As illustrated in Fig. 19, in the imaging device 100C, routes ("voltage supply routes C to 113B" hereinafter) for supplying the power supply voltage or the reference voltage from the bump electrodes 41 arranged at the positions overlapping the peripheral region R2 in the Z-axis direction to the logic circuits 113B via the large-diameter vias 91, the wiring 75, the micro-vias 81, and the contacts 83 are provided. In the imaging device 100D, the power supply voltage or the reference voltage is supplied to the logic circuits 113B via the "voltage supply routes C to 113B".

With the imaging device 100D, since resistance of the voltage supply routes to the logic circuits 113B can be further reduced by arranging the large-diameter vias 91, it is possible to further suppress IR drop.

Note that, in the imaging device 100C, at least the "voltage supply routes A to 113B" or the "voltage supply routes B to 113B" illustrated in Fig. 17 may be provided. Since the imaging device 100D includes at least the "voltage supply routes A to 113B" or the "voltage supply routes B to 113B" in addition to the "voltage supply routes C to 113B", resistance values of the voltage supply routes to the logic circuit 113B can be further reduced.

### <Other Embodiments>

As described above, the present disclosure is described according to the embodiments and modifications thereof, but it should not be understood that the description and drawings forming a part of this disclosure limit the present disclosure. Various alternative embodiments, examples, and operation techniques will be apparent to those skilled in the art from this disclosure. For example, the logic board 2 is not limited to a case where the logic board 2 includes one or two semiconductor substrates. The logic board 2 may be obtained by bonding three or more semiconductor substrates with a wiring layer interposed therebetween. Furthermore, MOS transistors or the like constituting a part of the logic circuits 113 may be provided on the semiconductor substrate 11 included in the sensor board 1.

Furthermore, any types of circuits may be provided on each of stacked boards (the sensor board 1 and the logic board 2). For example, in a case where an imaging device according to an embodiment of the present disclosure includes a two-layer structure of an upper board (for example, the sensor board 1) and a lower board (for example, the logic board 2) as with the imaging device 100 illustrated in Fig. 4 or the imaging device 100A illustrated in Fig. 11, a subset of the pixel circuits (for example, the read circuit 115), other signal processing circuits and drive circuits, and/or the like illustrated in Fig. 2 may be arranged on the lower board. All the pixel circuits (for example, the pixels 102) illustrated in Fig. 2 may be arranged on the upper board, and other signal processing circuits and drive circuits may be arranged on the lower board.

Even in a case where the imaging device according to an embodiment of the present disclosure has a three-layer structure of an upper board (for example, the sensor board 1), an intermediate board (a part of the logic board 2), and a lower board (another part of the logic board 2) as with the imaging device 100B illustrated in Fig. 13, the imaging device 100C illustrated in Fig. 16, or the imaging device 100D illustrated in Fig. 18, a subset or all of the pixel circuits illustrated in Fig. 2 or a signal processing circuit (for example, the column signal processing circuit 105 illustrated in Fig. 1) such as an ADC may be appropriately arranged on each board.

Furthermore, in the imaging device 100 illustrated in Fig. 4 or the imaging device 100 A illustrated in Fig. 11, circuits mounted on the lower board (for example, the logic board 2) is not limited to the logic circuits 113 and the pixel circuits. The circuits mounted on the lower board may be any various circuits including analog circuits and/or logic circuits, such as signal processing circuits, drive circuits, and control circuits.

Similarly, circuits mounted on the intermediate board (a part of the logic board 2) and the lower board (another part of the logic board 2) of the imaging device 100B illustrated in Fig. 13, the imaging device 100C illustrated in Fig. 16, or the imaging device 100D illustrated in Fig. 18 are not limited to the logic circuits 113 and the pixel circuits. The circuits mounted on the intermediate board and the lower board may be any various circuits including analog circuits and/or logic circuits such signal processing circuits, drive circuits, and control circuits.

As described above, it is a matter of course that the present disclosure includes various embodiments and the like not described herein. At least one of various omissions, substitutions, or changes of the components may be made without departing from the gist of the above-described embodiments and modifications. Furthermore, the effect described in the present description is illustrative only; the effect is not limited thereto and there may also be another effect. The technical scope of the present disclosure is defined only by the matters specifying the invention according to the claims that are appropriate from the above description.

### <Example of Application to Electronic Apparatus>

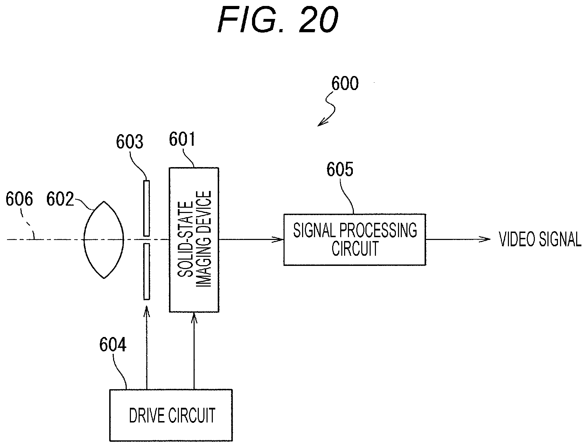

The technology according to the present disclosure (present technology) can be applied to an electronic apparatus. Fig. 20 is a diagram illustrating a configuration example of an electronic apparatus 600 to which the present technology can be applied. As illustrated in Fig. 20, the electronic apparatus 600 includes a solid-state imaging device 601, an optical lens 602 (an example of an "optical system" of the present disclosure), a shutter device 603, a drive circuit 604, and a signal processing circuit 605. The electronic apparatus 600 is not limited to this, but is an electronic apparatus such as, for example, a camera. Furthermore, the electronic apparatus 600 includes, as the solid-state imaging device 601, any one or more of the imaging devices 100, 100A, 100B, 100C, and 100D illustrated in Figs. 4, 11, 13, 16, 18, and the like described above.

The optical lens 602 forms an image of image light (incident light 606) from a subject on the imaging surface of the solid-state imaging device 601. As a result, signal charges are accumulated in the solid-state imaging device 601 over a certain period of time. The shutter device 603 controls a light irradiation period and a light shielding period for the solid-state imaging device 601. The drive circuit 604 supplies a drive signal for controlling a transfer operation of the solid-state imaging device 601 and a shutter operation of the shutter device 603. In accordance with a drive signal (a timing signal) supplied from the drive circuit 604, the solid-state imaging device 601 performs signal transfer. The signal processing circuit 605 performs various kinds of signal processing on a signal (pixel signal) that is output from the solid-state imaging device 601. A video signal subjected to the signal processing is stored into a storage medium such as a memory, or is output to a monitor.

With such a configuration, since the electronic apparatus 600 includes, as the solid-state imaging device 601, any one or more of the imaging devices 100, 100A, 100B, 100C, and 100D capable of suppressing deterioration of device characteristics due to IR drop, deterioration of performance can be suppressed.

Note that the electronic apparatus 600 is not necessarily a camera, and may be another electronic apparatus, instead. For example, the electronic apparatus 600 may be an imaging device such as a camera module for a mobile device such as a mobile phone.

### <Example of Application to Endoscopic Surgery System>

The technology according to the present disclosure (the present technology) can be applied to various products. For example, the technology according to the present disclosure may be applied to an endoscopic surgery system.

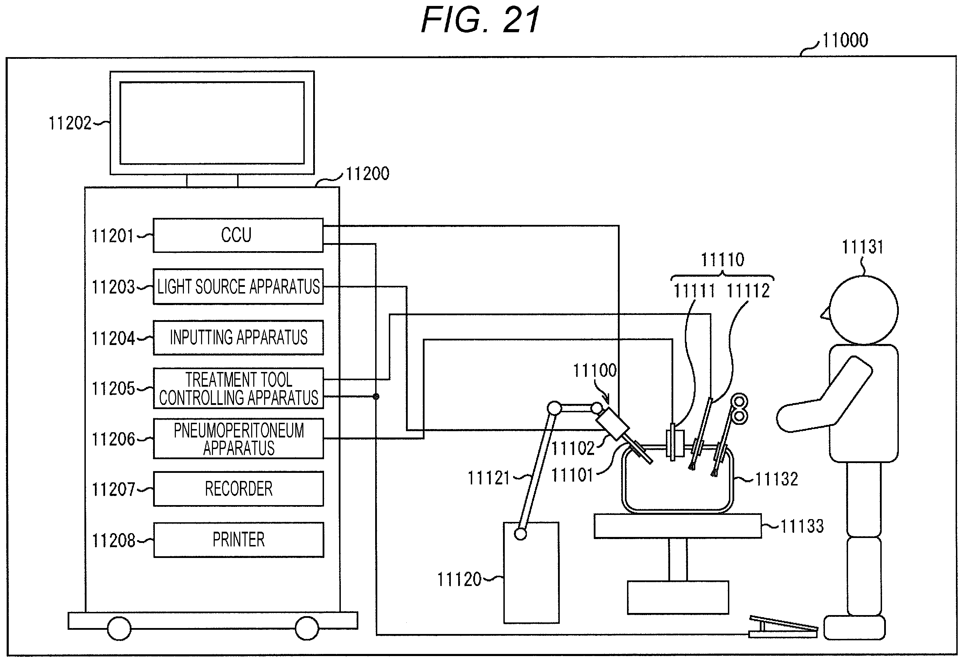

Fig. 21 is a diagram illustrating an example of a schematic configuration of an endoscopic surgery system to which the technology of the present disclosure (present technology) can be applied.

Fig. 21 illustrates a state in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as a light emitting diode (LED), for example, and supplies irradiation light for imaging a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

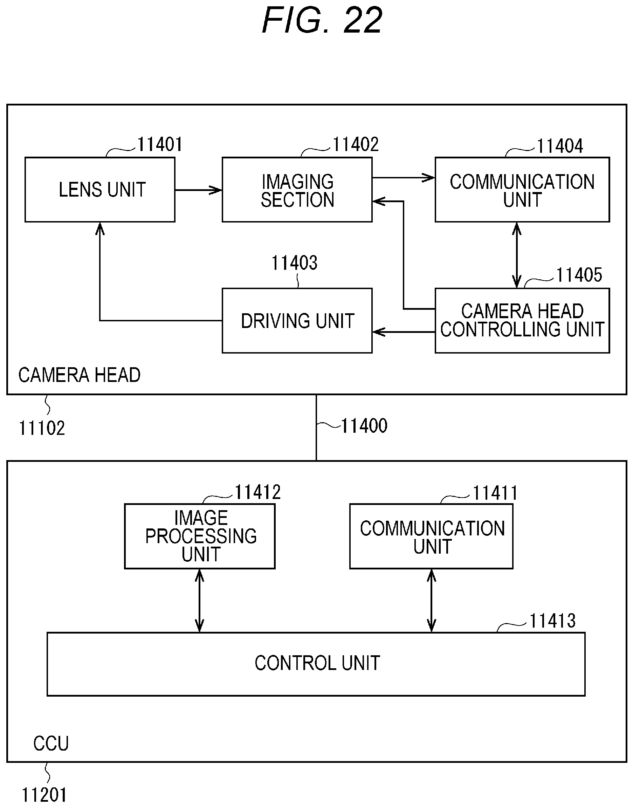

Fig. 22 is a block diagram illustrating an example of a functional configuration of the camera head 11102 and the CCU 11201 illustrated in Fig. 21.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The imaging pickup unit 11402 includes imaging elements. The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. Alternatively, the imaging pickup unit 11402 may include a pair of image pickup elements for obtaining right-eye and left-eye image signals corresponding to three-dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technology according to the present disclosure can be applied has been described above. The technology according to the present disclosure can be applied to, for example, the endoscope 11100, the imaging pickup unit 11402 of the camera head 11102, the image processing unit 11412 of the CCU 11201, and the like among the above-described configurations. More specifically, the imaging devices 100, 100A, 100B, 100C, and 100D illustrated in Figs. 4, 11, 13, 16, 18, and the like can be applied to the imaging pickup unit 10402. By applying the technology according to the present disclosure to the endoscope 11100, the imaging pickup unit 11402 of the camera head 11102, the image processing unit 11412 of the CCU 11201, and the like, a clearer surgical region image can be obtained, and the surgeon can reliably check the surgical region. Furthermore, by applying the technology according the present disclosure to the endoscope 11100, the imaging pickup unit 11402 of the camera head 11102, the image processing unit 11412 of the CCU 11201, and the like, the surgical region image can be obtained with lower latency, and thus treatment with a feeling similar to that in a case where the surgeon performs tactile observation of the surgical region can be performed.

Note that an endoscopic surgery system has been described as an example herein, but the technology according to the present disclosure may be applied to a microscopic surgery system or the like, for example.

### <Example of Application to Mobile Body>

The technology according to the present disclosure (the present technology) can be applied to various products. For example, the technology of the present disclosure may be implemented as a device mounted on any type of mobile body such as an automobile, an electric vehicle, a hybrid electric vehicle, a motorcycle, a bicycle, a personal mobility, an airplane, a drone, a ship, a robot, and the like.

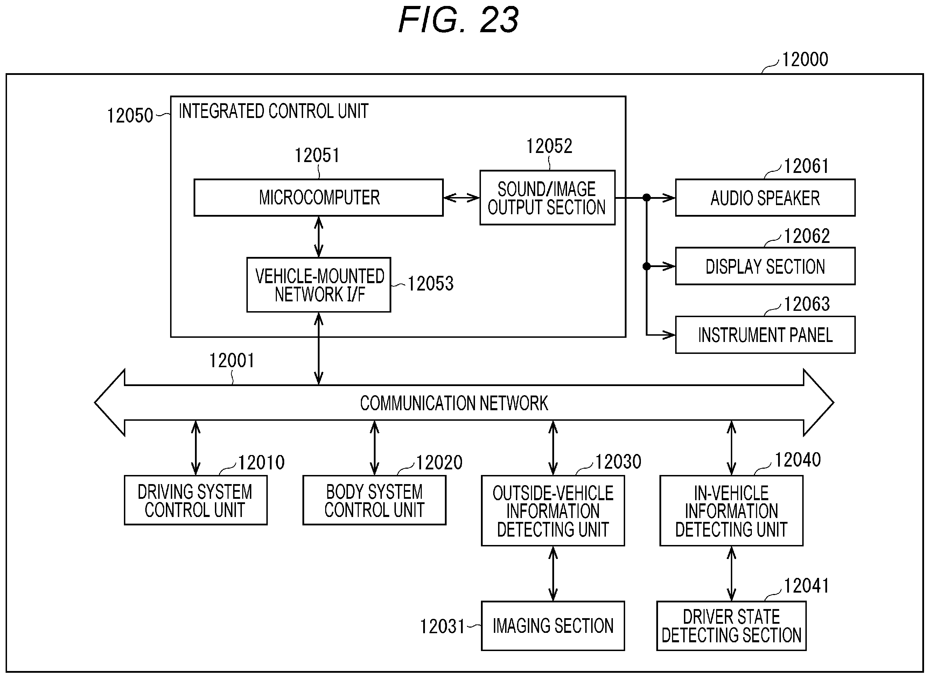

Fig. 23 is a block diagram illustrating a schematic configuration example of a vehicle control system which is an example of a mobile body control system to which the technology of the present disclosure can be applied.

The vehicle control system 12000 includes a plurality of electronic control units connected to each other via a communication network 12001. In the example illustrated in Fig. 23, the vehicle control system 12000 includes a driving system control unit 12010, a body system control unit 12020, an outside-vehicle information detecting unit 12030, an in-vehicle information detecting unit 12040, and an integrated control unit 12050. Furthermore, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

Furthermore, the microcomputer 12051 can output a control command to the body system control unit 12020 on the basis of the information about the outside of the vehicle obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 23, an audio speaker 12061, a display section 12062, and an instrument panel 12063 are illustrated as the output device. The display section 12062 may, for example, include at least one of an on-board display and a head-up display.

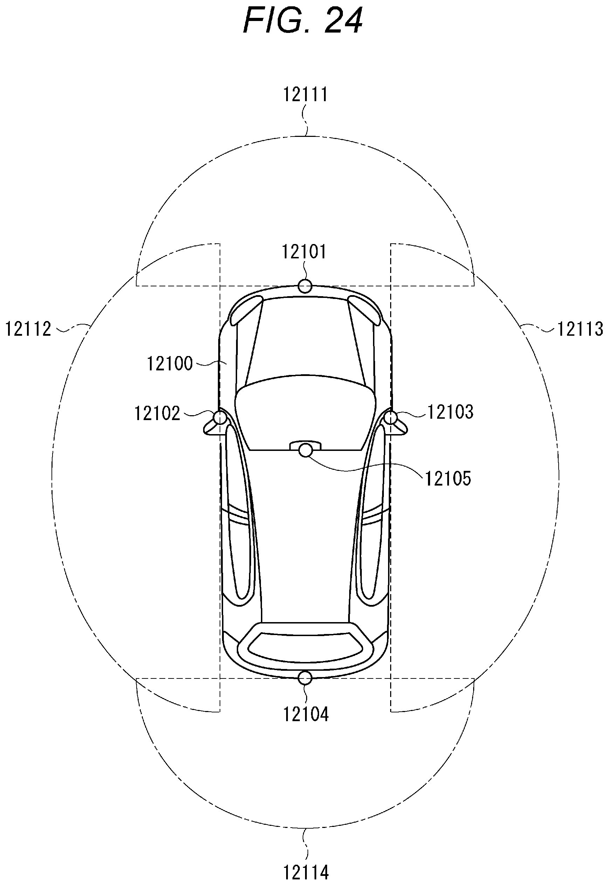

Fig. 24 is a view illustrating an example of the installation position of the imaging section 12031.

In Fig. 24, a vehicle 12100 includes imaging sections 12101, 12102, 12103, 12104, and 12105 as the imaging section 12031.

The imaging sections 12101, 12102, 12103, 12104, and 12105 are, for example, arranged at positions on a front nose, sideview mirrors, a rear bumper, and a back door of the vehicle 12100 as well as a position on an upper portion of a windshield within an interior of the vehicle, and the like. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The forward images obtained by the imaging sections 12101 and 12105 are used mainly to detect a preceding vehicle, a pedestrian, an obstacle, a traffic signal, a traffic sign, a lane, or the like.

Note that Fig. 24 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to the imaging section 12031 and the like in the configuration described above. More specifically, the imaging devices 100, 100A, 100B, 100C, and 100D illustrated in Figs. 4, 11, 13, 16, 18, and the like can be applied to the imaging section 12031. By applying the technology according to the present disclosure to the imaging section 12031, it is possible to obtain a captured image that is easier to view, thereby making it possible to reduce driver fatigue.

Note that the present disclosure can also have the following configurations.
(1) An imaging device including:
   a sensor board including a pixel region in which a plurality of pixels that performs photoelectric conversion is arranged side by side;
   a circuit board bonded to one surface side of the sensor board, the circuit board including circuits that process signals input to the sensor board or signals output from the sensor board; and
   a voltage supply terminal that is provided on an opposite side of a surface of the circuit board facing the sensor board and that supplies a power supply voltage or a reference voltage to the circuits, in which
   at least a subset of the voltage supply terminal is arranged at a position overlapping the pixel region in a thickness direction of a multilayer board including the sensor board and the circuit board.
(2) The imaging device according to (1), in which
   the circuit board includes:
   a first semiconductor layer having a first surface facing the sensor board and a second surface located on an opposite side of the first surface,
   a first wiring layer arranged on the first surface side of the first semiconductor layer, and
   first vias penetrating between the first surface and the second surface of the first semiconductor layer,
   the first vias are arranged at positions overlapping the pixel region in the thickness direction of the multilayer board, and
   at least a subset of the voltage supply terminal is connected to the first wiring layer via the first vias.
(3) The imaging device according to (2), in which
   diameter of the first vias is larger than or equal to a minimum gate length of transistors included in the circuits and smaller than or equal to 1000 nm.
(4) The imaging device according to (2) or (3), in which
   the circuit board includes:
   a second wiring layer arranged on the second surface side of the first semiconductor layer, and
   the voltage supply terminal is connected to the first vias via the second wiring layer.
(5) The imaging device according to any one of (1) to (4), further including:
   signal terminals that are provided on the opposite side of the surface of the circuit board facing the sensor board and that input signals to the circuits or output signals from the circuits, in which
   the sensor board has a peripheral region located around the pixel region, and
   at least a subset of the signal terminals is arranged at positions overlapping the peripheral region in the thickness direction of the multilayer board.
(6) The imaging device according to (5), in which
   the circuit board includes:
   a first semiconductor layer having a first surface facing the sensor board and a second surface located on an opposite side of the first surface,
   a first wiring layer arranged on the first surface side of the first semiconductor layer, and
   second vias penetrating between the first surface and the second surface of the first semiconductor layer,
   the second vias are arranged at positions overlapping the peripheral region in the thickness direction of the multilayer board, and
   at least a subset of the signal terminals is connected to the first wiring layer via the second vias.
(7) The imaging device according to (6), in which
   the circuit board includes first vias penetrating between the first surface and the second surface of the first semiconductor layer,
   the first vias are arranged at positions overlapping the pixel region in the thickness direction of the multilayer board,
   at least a subset of the voltage supply terminal is connected to the first wiring layer via the first vias, and
   diameter of the second vias is larger than diameter of the first vias.
(8) The imaging device according to any one of (2) to (4), (6), and (7), in which
   the sensor board includes:
   a second semiconductor layer provided with the plurality of pixels, and
   a third wiring layer arranged between the second semiconductor layer and the circuit board, and
   a part of a conductor included in the first wiring layer and a part of a conductor included in the third wiring layer are bonded to each other.
(9) The imaging device according to any one of (1) to (7), in which the sensor board includes:
   a second semiconductor layer provided with the plurality of pixels, and
   a third wiring layer arranged between the second semiconductor layer and the circuit board,
   the circuit board includes:
      a third semiconductor layer having a third surface facing the sensor board and a fourth surface located on an opposite side of the third surface, and
      a fourth wiring layer arranged on a third surface side of the third semiconductor layer, and
      a part of a conductor included in the fourth wiring layer and a part of a conductor included in the third wiring layer are bonded to each other.
(10) The imaging device according to (9), in which
   the circuit board includes a fifth wiring layer arranged on a fourth surface side of the third semiconductor layer, and
   a part of a conductor included in the fifth wiring layer and a part of a conductor included in the first wiring layer are bonded to each other.
(11) The imaging device according to (10), in which
   the circuit board includes third vias penetrating between the third surface and the fourth surface of the third semiconductor layer and connecting the fourth wiring layer and the fifth wiring layer to each other, and
   the third vias are arranged at positions overlapping the pixel region in the thickness direction of the multilayer board.
(12) The imaging device according to (11), in which
   diameter of the third vias is larger than or equal to a minimum gate length of transistors included in the circuits and smaller than or equal to 1000 nm.
(13) The imaging device according to (11) or (12), in which
   the circuit board includes fourth vias penetrating between the third surface and the fourth surface of the third semiconductor layer and connecting the fourth wiring layer and the fifth wiring layer to each other,
   the sensor board has a peripheral region located around the pixel region, and
   the fourth vias are arranged at positions overlapping the peripheral region in the thickness direction of the multilayer board.
(14) The imaging device according to (13), in which
   diameter of the fourth vias is larger than diameter of the third vias.
(15) The imaging device according to any one of (1) to (14), further including:
   a plurality of the voltage supply terminals, in which
   the plurality of voltage supply terminals is arranged side by side in a first direction and a second direction intersecting the first direction in plan view from the thickness direction of the multilayer board.
(16) The imaging device according to any one of (1 to 15, further including:
   a lens provided on an opposite side of the one surface of the sensor board; and
   a color filter provided between the lens and the sensor board.
(17) An electronic apparatus including:
   an imaging device; and
   an optical system that causes the imaging device to form an image of image light from a subject, in which
   the imaging device includes:
      a sensor substrate having a pixel region in which a plurality of pixels that performs photoelectric conversion is arranged side by side,
      a circuit board bonded to one surface side of the sensor board, the circuit board including circuits that process signals input to the sensor board or signals output from the sensor board, and
      a voltage supply terminal that is provided on an opposite side of a surface of the circuit board facing the sensor board and that supplies a power supply voltage or a reference voltage to the circuits, and
      at least a subset of the voltage supply terminal is arranged at a position overlapping the pixel region in a thickness direction of a multilayer board including the sensor board and the circuit board.

### REFERENCE SIGNS LIST

1, 1' 301 Sensor board
1a, 2a, 11a, 12a, 21a, 61a, 111a Front surface
1b, 2b, 10b, 11b, 21b, 61b, 111b Back surface
2, 2' 302 Logic board
3 Multilayer board
11, 21, 61, 71, 321Semiconductor substrate
12 Separation unit
13, 23, 33, 63, 73 Wiring layer
14, 24, 34, 64, 74 Interlayer insulating film
15, 25, 25m, 25n, 35, 65, 75 Wiring
16, 26, 66, 76 Connection pad
17, 27, 37, 67, 77, 78, 91 Via
41 Bump electrode (for supplying voltages)
42 Bump electrode (for transmitting and receiving signals)
51, 52, 81, Micro-via
51a, 51b, 78a, 78b End
53, 54, 83 Contact
55, 68 Insulating film
56 Adhesive sheet
57 Support board
58 Protective sheet
100, 100A, 100B, 100C, 100D, 400, 500 Imaging device
102 Pixel
104 Vertical drive circuit
105 Column signal processing circuits
106 Horizontal drive circuit
107 Output circuit
108 Control circuit
109 Vertical signal line
110 Horizontal signal line
111 Multilayer board
112 Input/output terminal
113, 113A, 113B, 413 Logic circuit
115 Read circuit
600 Electronic apparatus
601 Solid-state imaging device
602 Optical lens
603 Shutter device
604 Drive circuit
605 Signal processing circuit
606 Incident light
10402 Imaging pickup unit
11000 Endoscopic surgery system
11100 Endoscope
11101 Lens barrel
11102 Camera head
11110 Surgical tool
11111 Pneumoperitoneum tube
11112 Energy device
11120 Supporting arm apparatus
11131 Surgeon (medical doctor)
11132 Patient
11133 Patient bed
11200 Cart
11201 Camera control unit (CCU)
11202 Display apparatus
11203 Light source apparatus
11204 Input apparatus
11205 Treatment tool controlling apparatus
11206 Pneumoperitoneum apparatus
11207 Recorder
11208 Printer
11400 Transmission cable
11401 Lens unit
11402 Imaging pickup unit
11403 Driving unit
11404 Communication unit
11405 Camera head controlling unit
11411 Communication unit
11412 Image processing unit
11413 Control unit
12000 Vehicle control system
12001 Communication network
12010 Driving system control unit
12020 Body system control unit
12030 Outside-vehicle information detecting unit
12031 Imaging section
12040 In-vehicle information detecting unit
12041 Driver state detecting section
12050 Integrated control unit
12051 Microcomputer
12052 Sound/image output section
12061 Audio speaker
12062 Display section
12063 Instrument panel
12100 Vehicle
12101, 12102, 12103, 12104, 12105 Imaging section
12111, 12112, 12113, 12114 Imaging range
A, B, C Voltage supply route
AMP Amplification transistor
CF Color filter
d1a, d1b, d2, d3 Diameter
DL Dicing line
FD Floating diffusion
H, H1, H2 Through hole
I Vehicle-mounted network
M1 to M5, M11 to M25, M31 to M33 Metal
OCL On-chip lens
PD Photodiode
R1 Pixel region
R2 Peripheral region
RST Reset transistor
SEL Selection transistor
TR Transfer transistor
Tr1 to Tr13 Pixel transistor

## Claims

1. An imaging device comprising:
a sensor board including a pixel region in which a plurality of pixels that performs photoelectric conversion is arranged side by side;
a circuit board bonded to one surface side of the sensor board, the circuit board including circuits that process signals input to the sensor board or signals output from the sensor board; and
a voltage supply terminal that is provided on an opposite side of a surface of the circuit board facing the sensor board and that supplies a power supply voltage or a reference voltage to the circuits, wherein
at least a subset of the voltage supply terminal is arranged at a position overlapping the pixel region in a thickness direction of a multilayer board including the sensor board and the circuit board.

2. The imaging device according to claim 1, wherein
the circuit board includes:
a first semiconductor layer having a first surface facing the sensor board and a second surface located on an opposite side of the first surface,
a first wiring layer arranged on the first surface side of the first semiconductor layer, and
first vias penetrating between the first surface and the second surface of the first semiconductor layer,
the first vias are arranged at positions overlapping the pixel region in the thickness direction of the multilayer board, and
at least a subset of the voltage supply terminal is connected to the first wiring layer via the first vias.

3. The imaging device according to claim 2, wherein
diameter of the first vias is larger than or equal to a minimum gate length of transistors included in the circuits and smaller than or equal to 1000 nm.

4. The imaging device according to claim 2, wherein
the circuit board includes:
a second wiring layer arranged on the second surface side of the first semiconductor layer, and
the voltage supply terminal is connected to the first vias via the second wiring layer.

5. The imaging device according to claim 1, further comprising:
signal terminals that are provided on the opposite side of the surface of the circuit board facing the sensor board and that input signals to the circuits or output signals from the circuits, wherein
the sensor board has a peripheral region located around the pixel region, and
at least a subset of the signal terminals is arranged at positions overlapping the peripheral region in the thickness direction of the multilayer board.

6. The imaging device according to claim 5, wherein
the circuit board includes:
a first semiconductor layer having a first surface facing the sensor board and a second surface located on an opposite side of the first surface,
a first wiring layer arranged on the first surface side of the first semiconductor layer, and
second vias penetrating between the first surface and the second surface of the first semiconductor layer,
the second vias are arranged at positions overlapping the peripheral region in the thickness direction of the multilayer board, and
at least a subset of the signal terminals is connected to the first wiring layer via the second vias.

7. The imaging device according to claim 6, wherein
the circuit board includes first vias penetrating between the first surface and the second surface of the first semiconductor layer,
the first vias are arranged at positions overlapping the pixel region in the thickness direction of the multilayer board,
at least a subset of the voltage supply terminal is connected to the first wiring layer via the first vias, and
diameter of the second vias is larger than diameter of the first vias.

8. The imaging device according to claim 2, wherein
the sensor board includes:
a second semiconductor layer provided with the plurality of pixels, and
a third wiring layer arranged between the second semiconductor layer and the circuit board, and
a part of a conductor included in the first wiring layer and a part of a conductor included in the third wiring layer are bonded to each other.

9. The imaging device according to claim 1, wherein
the sensor board includes:
a second semiconductor layer provided with the plurality of pixels, and
a third wiring layer arranged between the second semiconductor layer and the circuit board,
the circuit board includes:
a third semiconductor layer having a third surface facing the sensor board and a fourth surface located on an opposite side of the third surface, and
a fourth wiring layer arranged on a third surface side of the third semiconductor layer, and
a part of a conductor included in the fourth wiring layer and a part of a conductor included in the third wiring layer are bonded to each other.

10. The imaging device according to claim 9, wherein
the circuit board includes a fifth wiring layer arranged on a fourth surface side of the third semiconductor layer, and
a part of a conductor included in the fifth wiring layer and a part of a conductor included in the first wiring layer are bonded to each other.

11. The imaging device according to claim 10, wherein
the circuit board includes third vias penetrating between the third surface and the fourth surface of the third semiconductor layer and connecting the fourth wiring layer and the fifth wiring layer to each other, and
the third vias are arranged at positions overlapping the pixel region in the thickness direction of the multilayer board.

12. The imaging device according to claim 11, wherein
diameter of the third vias is larger than or equal to a minimum gate length of transistors included in the circuits and smaller than or equal to 1000 nm.

13. The imaging device according to claim 11, wherein
the circuit board includes fourth vias penetrating between the third surface and the fourth surface of the third semiconductor layer and connecting the fourth wiring layer and the fifth wiring layer to each other,
the sensor board has a peripheral region located around the pixel region, and
the fourth vias are arranged at positions overlapping the peripheral region in the thickness direction of the multilayer board.

14. The imaging device according to claim 13, wherein
diameter of the fourth vias is larger than diameter of the third vias.

15. The imaging device according to claim 1, further comprising:
a plurality of the voltage supply terminals, wherein
the plurality of voltage supply terminals is arranged side by side in a first direction and a second direction intersecting the first direction in plan view from the thickness direction of the multilayer board.

16. The imaging device according to claim 1, further comprising:
a lens provided on an opposite side of the one surface of the sensor board; and
a color filter provided between the lens and the sensor board.

17. An electronic apparatus comprising:
an imaging device; and
an optical system that causes the imaging device to form an image of image light from a subject, wherein
the imaging device includes:
a sensor substrate having a pixel region in which a plurality of pixels that performs photoelectric conversion is arranged side by side,
a circuit board bonded to one surface side of the sensor board, the circuit board including circuits that process signals input to the sensor board or signals output from the sensor board, and
a voltage supply terminal that is provided on an opposite side of a surface of the circuit board facing the sensor board and that supplies a power supply voltage or a reference voltage to the circuits, and
at least a subset of the voltage supply terminal is arranged at a position overlapping the pixel region in a thickness direction of a multilayer board including the sensor board and the circuit board.
